# EUROPÄISCHE PATENTSCHRIFT

(11) **EP 2 503 257 B1**
(45) Veröffentlichungstag und Bekanntmachung des Hinweises auf die Patenterteilung: **19.02.2014**
(21) Anmeldenummer: 11159135.0
(22) Anmeldetag: 22.03.2011
(51) Int. Cl.: F24F 11/00, A62B 31/00, A62C 2/18, H02B 1/28, F16K 3/02, F24F 1/02, H05K 7/20, F24F 13/20

(54) **Shelter**
Shelter
Abri

(43) Veröffentlichungstag der Anmeldung: 26.09.2012
(73) Patentinhaber: Gasser, Erwin, 3123 Belp (CH)
(72) Erfinder: Gasser, Erwin, 3123 Belp (CH)
(74) Vertreter: AMMANN PATENTANWÄLTE AG BERN

(56) Entgegenhaltungen:
- EP-A1- 1 367 331
- EP-A1- 2 030 651
- WO-A1-2010/049482
- WO-A2-2008/128311
- DE-A1- 4 328 810
- DE-A1- 19 914 408

## Beschreibung

Die Erfindung betrifft einen Shelter mit einem Gehäuse zur Begrenzung eines klimatisierbaren Innenraums und einem aussenseitig an dem Gehäuse befestigten Behälter, der einen Behälterraum zur Aufnahme einer Kühlungseinrichtung aufweist, die zur Kältezuführung in den Innenraum ausgebildet ist.

Herkömmlicherweise wird ein solcher Shelter als transportabler Schutz- oder Unterstellraum für informationstechnische Anlagen oder andere Verlustwärme erzeugende Einbauten verwendet, welche für einen störungsfreien Betrieb eine geregelte Umgebungstemperatur benötigen. Zu diesem Zweck ist an der Aussenwandung des Shelters ein Behälter zur Aufnahme eines Lüftungsgeräts befestigt, das über in dem Sheltergehäuse vorhandene Zuluftkanäle für die benötigte Kühlung der Einbauten sorgt. Bei bekannten Sheltern wird die Abwärme eines in dem Behälter eingebauten Verflüssigers über einen separaten Abluftkanal an die Shelterumgebung abgegeben, was insbesondere bei hohen Umgebungslufttemperaturen zu einem geringen Wirkungsgrad des Verflüssigers führt, so dass die Leistung der Kälteanlage bei hohen Umgebungslufttemperaturen stark abnimmt.

Bei dem aus der DE 43 28 810 A1 bekannten Shelter ist in den Behälter zudem eine ABC-Schutzbelüftungsanlage integriert, um eine schadstofffreie Luftzuführung zu gewährleisten. Weiterhin ist in der DE 34 06 628 A1 offenbart, den äusseren Behälter mit einer allseitig geschlossenen Verkleidung auszustatten, damit die Funktionsfähigkeit des Lüftungsgeräts nicht durch Umwelteinflüsse wie Staub oder Regengüsse beeinträchtigt werden kann. Durch diese Massnahmen soll ein erhöhten Schutz der in dem Shelterinnenraum untergebrachten Geräte auf zweierlei Weise erreicht werden. Einerseits soll die Qualität der zugeführten Frischluft durch technische Verbesserungen an dem äusseren Lüftungsgerät erhöht werden. Andererseits wird versucht, die Störungsanfälligkeit des Lüftungsgeräts gegenüber Umwelteinflüssen durch Verbesserung des am Shelter befestigten Gerätebehälters zu vermindern.

Allerdings bleibt dabei unberücksichtigt, dass bereits durch eine komplexere Ausgestaltung des Lüftungsgeräts dessen Störanfälligkeit zunimmt, ohne dass es dabei auf äussere Faktoren ankommt. Ohnehin hängt bei den bekannten Sheltern die geschützte Unterbringung der Einbauten von einem tadellosen Funktionieren der Belüftungsanlage ab und mögliche Konsequenzen eines Störfalls werden vernachlässigt. Insgesamt wäre es also wünschenswert, den Shelter im Hinblick auf dessen Klimatisierungsfunktion und auf dessen Schutzfähigkeit vor schädigenden Umwelteinflüssen so zu verbessern, dass eine störungssichere und ununterbrochene Aufrechterhaltung eines gleichmässigen Raumklimas für die empfindlichen Einbauten auf energieeffiziente Weise ermöglicht ist.

In der WO 2010/049482 A1 ist eine Klimatisierungsvorrichtung für Schaltschränke offenbart, welche in baulicher Nähe zu einem Schaltschrank angebracht ist und mittels zum Schaltschrank weisenden Öffnungen eine Luftzirkulation zwischen dem Schaltschrank und der Klimatisierungsvorrichtung ermöglicht. Die. Klimatisierungsvorrichtung umfasst einen drehzahlvariablen Kompressor für ein gasförmiges Kältemittel und einen Kondensator, von welchem die Kompressionswärme aufgenommen und durch eine äussere Öffnung an die Umgebung abgegeben wird. Durch Aktivierung einer Drosselklappe kann die Klimatisierung des Schaltschranks auch direkt über eine äussere Öffnung durch die Umgebungsluft erfolgen.

Eine Aufgabe der vorliegenden Erfindung besteht deshalb darin, den eingangs genannten Shelter derart weiterzubilden, dass er einen hohen Schutz gegenüber Betriebsschäden der Kühlungseinrichtung und/oder sonstige schädigende äussere Einflüsse liefert und dabei eine zuverlässige und/oder energieeffiziente Kältezuführung in den Innenraum auch über einen längeren Zeitraum hinweg sichergestellt ist.

Die genannte Aufgabe wird durch einen Shelter gemäss Patentanspruch 1 gelöst. Bevorzugte Ausführungsformen der Erfindung sind durch die abhängigen Patentansprüche definiert.

Erfindungsgemäss wird also vorgeschlagen, dass das Gehäuse mindestens einen Durchgang zur Wärmerückführung vom Innenraum in den Behälterraum aufweist. Auf diese Weise ist ein geschlossener Wärmekreislauf zwischen Gehäuseinnenraum und Behälterraum gebildet, der von der Shelterumgebung abgetrennt ist. Der geschlossene Wärmekreislauf kann vorteilhaft für eine zuverlässige und energieeffiziente Kühlung des Innenraums genutzt werden, welche von der momentanen Temperatur der Umgebungsluft unabhängig ist. Der geschlossene Wärmekreislauf bringt zudem auch sicherheitstechnische Vorteile mit sich, da der Shelter auf diese Weise autark von der Aussenumgebung betrieben werden kann und äussere Störeinflüsse im Wesentlichen vollständig vom Shelterinnenraum abgeschirmt werden können.

Gemäss einer bevorzugten Weiterbildung wird vorgeschlagen, dass das Gehäuse eine feuerfeste Materialschicht zum Abdecken eines Grenzbereichs zwischen dem Behälterraum und dem Innenraum aufweist, um dadurch eine gegenseitige Brandabschottung zu bewirken. Diese Massnahme beruht auf der Erkenntnis, dass eine hohe Gefahr für die in dem Shelter untergebrachten Werte auch von potentiellen Brandherden innerhalb des Behälterraums ausgehen kann. Erfindungsgemäss kann diese Gefahrenquelle durch die Brandabschottung zwischen dem Innenraum und dem Behälterraum mittels der feuerfesten Materialschicht eingedämmt werden.

In bevorzugter Ausgestaltung ist die feuerfeste Materialschicht derart entlang einer Wand des Gehäuses angeordnet, dass eine Brandabschottung im Wesentlichen über die gesamte Oberfläche der Gehäusewand bewirkt ist. Weiter bevorzugt ist die feuerfeste Materialschicht in allen Seitenwänden des Gehäuses ausgebildet. Dadurch kann eine hochgradige Brandabschottung des Innenraums nicht nur im Hinblick auf den Behälterraum sondern auch auf die übrigen angrenzenden Umgebungsbereiche sichergestellt werden. Höchst bevorzugt sind aus diesem Grund auch die Bodenwandung und die Deckenwandung des Gehäuses mit einer feuerfesten Materialschicht ausgestattet.

Eine hochgradige Brandabschottung, insbesondere mit einer Brandbeständigkeit T90 nach DIN 4102 und einer Rauchhemmung RS1 nach DIN 18095, kann beispielsweise dadurch erreicht werden, dass die feuerfeste Materialschicht eine Silikatplatte umfasst, insbesondere eine Kalziumsilikatplatte. Dadurch kann eine Wärmetransmission und/oder Dampfdiffusion wirkungsvoll verhindert werden.

Vorzugsweise wird ein derartiges Material als brandschützendes Kernmaterial eingesetzt, das zumindest abschnittsweise an seiner äusseren und/oder inneren Oberflächenseite von einer selbsttragenden Verkleidung umgeben ist. Höchst bevorzugt ist das Kernmaterial sowohl an der äusseren als auch an der inneren Oberflächenseite des Gehäuses von jeweils einer solchen selbsttragenden Verkleidung umgeben, wodurch eine doppelte Stützkonstruktion für die feuerfeste Materialschicht bereitgestellt wird. Durch die Verschachtelung mehrerer selbsttragender Materialebenen kann im Brandfall selbst nach einem Wegschmelzen der äusseren Stützkonstruktion mit Hilfe der autarken inneren Stützkonstruktion(en) die notwendige Stabilität des Shelters zum Schutz der im Innenraum eingelagerten Werte bereitgestellt werden, insbesondere gegen Hitze und Trümmerlasten. Vorzugsweise weist ein derartiges Kernmaterial mindestens eine Dicke von 40 mm auf, damit ein hoher Feuerwiderstandswert gewährleistet ist.

Als selbsttragende Aussenverkleidung und/oder Innenverkleidung wird vorzugsweise eine Metallplatte, insbesondere eine Inox-Stahlplatte, verwendet. Durch eine solche Metallhülle kann eine hohe Wärmereflektion und Wärmeumverteilung erreicht werden. Neben der Eigenschaften als Kühlkörper kann die Metallhülle auch zur thermischen Inkraftsetzung eines hohen Feuerwiderstandswertes der darunterliegenden feuerfesten Materialschicht dienen. Gemäss einer bevorzugten Weiterbildung werden ausserdem die stabilen mechanischen Eigenschaften der Metallhülle, insbesondere einer harten und robusten Inox-Stahlhülle, dazu eingesetzt, eine Sicherheitsmantelung des Shelters gegen Einbrüche bereitzustellen, die beispielsweise den Anforderungen einer Einbruchshemmung WK3 nach DIN V ENV 1627 genügen können. Ausserdem kann dadurch ein Faradayscher Käfig gegen elektromagnetische Strahlungsfelder (EMP), insbesondere gegen Blitzschlag und/oder gegen externe kompromittierende Strahlung, bereitgestellt werden. Vorzugsweise ist das Material der Aussenverkleidung und/oder Innenverkleidung derart gewählt, dass dadurch auch ein Schutz des Innenraums vor ionisierender Strahlung (NEMP) bewirkt ist.

Vorzugsweise ist auch die feuerfeste Materialschicht selbsttragend ausgebildet, um die hohe Brandsicherheit zu gewährleisten. Zu diesem Zweck kann die feuerfeste Materialschicht an ihrer Aussenkante mindestens einen Stützträger aufweisen, insbesondere einen Stahlträger, um eine stabile Befestigung mit den angrenzenden Gehäusekomponenten zu erreichen.

Ein besonderer Schutz gegen korrosive Rauchgase und/oder Wassereinbruch kann dadurch erreicht werden, dass Fugen oder Zwischenräume, die zwischen einzelnen Gehäusekomponenten vorhanden sind, durch brandschützendes und/oder wasserabweisendes Material abgedichtet werden, insbesondere einen Brandschutzkitt.

Vorzugsweise ist in dem Behälterraum mindestens eine Kühlungseinrichtung zur Kältezuführung in den Innenraum angeordnet. Bevorzugt ist die Kühlungseinrichtung nur zur Kühlung des Innenraums und/oder der darin befindlichen Einbauten ausgebildet. Alternativ kann es sich bei der Kühlungseinrichtung auch um mindestens eine Klimatisierungseinrichtung handeln, die neben der Kältezuführung im Bedarfsfall auch zur Wärmezuführung in den Innenraum ausgebildet ist.

Gemäss einer bevorzugten Ausführungsform des Shelters ist der Durchgang zur Wärmerückführung durch mindestens eine Kanalöffnung zur Rückführung von Warmluft vom Gehäuseinnenraum in den Behälterraum gebildet. In bevorzugter Ausgestaltung sind in mindestens einer Seitenwand des Gehäuses zwei Kanalöffnungen angeordnet, die in den Behälterraum münden. Weiterhin kann im dazwischenliegenden Bereich der zwei Kanalöffnungen ein Wärmetauscher einer Kühlungseinrichtung angeordnet werden, die zur Luftzuführung in den Innenraum durch die eine Kanalöffnung und zur Luftrückführung von dem Innenraum durch die andere Kanalöffnung ausgebildet ist. Auf diese Weise ist ein geschlossener Lüftungskreislauf zwischen Gehäuseinnenraum und Behälterraum gebildet, der neben einer zuverlässigen und energieeffizienten Benutzung auch sicherheitstechnische Vorteile mit sich bringt, da auf die Zuführung von eventuell kontaminierter Frischluft von der Aussenumgebung verzichtet werden kann. Bei einem solchen Shelter ist deshalb eine zusätzliche Anordnung einer ABC-Schutzbelüftungsanlage zur Reinigung von Frischluft aus der Aussenumgebung nicht nötig.

Zur optimierten Kühlung des Innenraums ist der Wärmetauscher bevorzugt auf mittlerer Höhe in dem Behälter angeordnet, wodurch in dem oberen und unteren Bereich des Behälterraums ein Freiraum für die ein- und austretenden Luftströmungen geschaffen ist. Vorzugsweise sind in dem Behälter, insbesondere in den oberen und unteren Kantenbereichen, Ablenkbleche zur Umleitung des Luftströmungswegs vorhanden. Für eine optimale Klimatisierung des Innenraums entspricht die Behälterhöhe vorzugsweise im Wesentlichen der Höhe des Sheltergehäuses.

Zur Erhöhung der Belüftungsqualität ist in dem geschlossenen Lüftungskreislauf bevorzugt mindestens ein Luftfilter angeordnet. Vorzugsweise sind innerhalb des Behälterraums mindestens zwei Luftfilter in dem Lüftungskreislauf hintereinandergereiht. Höchst bevorzugt ist ein Grobstaubfilter zur Grobfiltrierung der eintretenden Rückluft im oberen Behälterbereich und/oder ein Feinstaubfilter zur Feinfiltrierung der abzugebenden Zuluft im unteren Behälterbereich angeordnet.

Zur energetisch vorteilhaften Abgrenzung der oberen und/oder unteren Behälterbereiche von dem mittleren Höhenbereich mit dem Wärmetauscher kann mindestens eine dazwischenliegende Trennplatte angeordnet sein. Die Trennplatte erstreckt sich vorzugsweise im Wesentlichen über die gesamte Querschnittsfläche des Behälters, wodurch ein unteres Behältervolumen für die Zuluft, die durch die eine Kanalöffnung abzuführen ist, und ein oberes Behältervolumen für die Rückluft, die durch die andere Kanalöffnung vom Gehäuseinnenraum zurückgeführt wird, voneinander abgegrenzt ist. Eine solche Trennplatte kann neben der effizienteren Nutzung der zur Klimatisierung eingesetzten Energie auch zur Stabilisierung des Behälters, insbesondere zu dessen Verwindungssteifigkeit, beitragen.

Die Trennplatte kann beispielsweise durch einen Träger eines Luftfilters, insbesondere einen Grobstaubfilter und/oder einen Feinstaubfilter, und/oder eine Auffangplatte für Kondenswasser im Behälterraum gebildet sein. Vorzugsweise ist an mindestens einer Trennplatte eine Ventilationseinrichtung angeordnet. An der Druckseite der Ventilationseinrichtung ist bevorzugt einer der Luftfilter, insbesondere ein Feinstaubfilter, angeordnet.

Eine effiziente Kühlung der Luftströmung im Behälterraum kann dadurch erreicht werden, dass der Wärmetauscher auf mittlerer Höhe in dem Behälter angeordnet ist, wodurch in dem oberen und unteren Bereich des Behälterraums ein Freiraum für die ein- und austretenden Luftströmungen geschaffen ist. Vorzugsweise sind in dem Behälter, insbesondere in den oberen und unteren Kantenbereichen, Ablenkbleche zur Umleitung des Luftströmungswegs vorhanden. Ein Wärmetauscher ist bevorzugt derart in dem Behälterraum angeordnet, dass seine Seitenkanten, die in der Höhenrichtung des Behälters verlaufen, in Bezug auf eine Rückwand des Behälters schräggestellt sind. Dadurch kann die Grösse der Wärmetauschfläche in Bezug auf das verfügbare Behältervolumen optimiert werden. Ausserdem lässt sich dadurch erreichen, dass die Luftströmung im Behälterraum derart an der Wärmetauschfläche vorbeigeleitet wird, dass dabei eine energieoptimierte Wärmeabgabe stattfindet.

Unter dem Begriff Wärmetauscher wird allgemein eine Einrichtung verstanden, die über einen physikalischen und/oder chemischen Prozess einen Austausch von Wärmeenergie zwischen zwei Medien ermöglicht. Beispielsweise kann der Wärmetauscher auf dem Funktionsprinzip einer Verdampfereinheit beruhen, oder als kaltwassergekühlter Wärmetauscher ausgebildet sein. Weiterhin können Wärmetauscher eingesetzt werden, die zur Luftkühlung oder zur Flüssigkeitskühlung des Innenraums und/oder der darin angeordneten Geräte geeignet sind. Vorzugsweise handelt es sich bei dem Wärmetauscher um ein Kühlregister, insbesondere um einen Lamellenwärmetauscher, welches sowohl für eine Luftkühlung als auch für eine Flüssigkeitskühlung eingesetzt werden kann.

Vorzugsweise ist die Schrägstellung des Wärmetauschers so gewählt, dass seine Unterkante einen grösseren Abstand von der Rückwand aufweist als seine Oberkante. Dadurch lässt sich der vorhandene Behälterraum für eine energieeffiziente Luftkühlung nutzen, insbesondere indem im Bereich der Unterkante des Wärmetauschers eine Ventilationseinrichtung angeordnet ist, wodurch eine vorteilhafte Verteilung der Luftströmung über das Behältervolumen erreicht werden kann. Weiterhin erstreckt sich der plattenförmige Wärmetauscher bevorzugt über die vollständige Breite der Seitenverkleidung des Behälters.

Gemäss einer bevorzugten Ausgestaltung der feuerfesten Materialschicht umfasst diese einen statischen Abschnitt, der ortsfest in dem Grenzbereich zwischen Behälterraum und Innenraum angeordnet ist, und einen aktivierbaren Abschnitt, durch den im Brandfall mindestens eine Kanalöffnung zwischen dem Behälterraum und dem Innenraum abdeckbar ist. Dabei wird vorzugsweise mindestens ein Lüftungsgerät als Kühlungseinrichtung verwendet, welches durch die abdeckbaren Kanalöffnungen für die Rückluft und die Zuluft von und zum Innenraum sorgt.

Weiterhin bevorzugt ist der aktivierbare Abschnitt an einer Seitenwand des Gehäuses angeordnet und weist eine Abdeckbreite auf, die mindestens zwei Dritteln der Breite, vorzugsweise im Wesentlichen der vollständigen Breite, der Seitenwand entspricht. Durch eine vorteilhafte Anordnung einer oder mehrerer Kanalöffnungen innerhalb der abdeckbaren Breite des Gehäuses kann somit eine optimale Belüftung des Innenraums erreicht werden und mit einer hochgradig sicheren Brandabschottung in Einklang gebracht werden.

Vorzugsweise erstreckt sich der Gehäuseabschnitt mit den Kanalöffnungen über mindestens zwei Drittel der Breite, vorzugsweise im Wesentlichen die vollständige Breite, einer Seitenwand. Durch die so gewählte Dimensionierung der Kanalöffnungen kann insbesondere eine geringe Temperaturdifferenz zwischen Lufteintritt und -austritt eines Lüftungskreislaufs sichergestellt werden, um bei der Klimatisierung des Gehäuseinnenraums die untergebrachten Apparate oder Wertgegenstände nicht zu schädigen. Vorzugsweise ist der aktivierbare Abschnitt durch mindestens einen Schutzschieber gebildet, der zwischen einer Offenstellung und einer Verschlussstellung der im Abdeckbereich vorgesehenen Kanalöffnungen verschiebbar gelagert ist. Eine besonders hochwertige und brandsichere Luftzuführung und Luftrückführung kann dabei durch zwei Schutzschieber erreicht werden, die in entgegengesetzter Richtung verschiebbar angeordnet sind. Dabei kann der technische Effekt einer gegenseitigen Gewichtskompensation dieser Schutzschieber verwendet werden, um ihre Aktivierung im Brandfall durch einen sehr geringen Kraftaufwand zu bewirken. Dies kann zur Zuverlässigkeit der Aktivierung im Brandfall beitragen und ermöglicht zudem den Einsatz schwergewichtiger hochwertiger Brandschutzmaterialien. Ein derartiger Schutzschieber ist aus der EP 2 030 651 A1 des gleichen Anmelders bekannt, deren Inhalt hiermit zum integralen Bestandteil der vorliegenden Patentanmeldung erklärt wird.

Gemäss einer anderen bevorzugten Ausgestaltung der feuerfesten Materialschicht besteht diese in mindestens einer Seitenwand des Gehäuses im Wesentlichen aus einem statischen Abschnitt, der ortsfest in dem Grenzbereich zwischen Behälterraum und Innenraum angeordnet ist, wobei in diesem statischen Abschnitt mindestens ein Durchgang zur Wärmerückführung vorhanden ist, durch welchen mindestens eine Leitung eines fluiden Wärmeträgers verläuft. In diesem Fall wird vorzugsweise mindestens eine Kühlungseinrichtung eingesetzt, welche für eine Flüssigkeitskühlung ausgebildet ist. Derart kann mittels der Leitungen des fluiden Wärmeträgers für die Kältezuführung und die Wärmerückführung aus dem Innenraum gesorgt werden. Beispielsweise können dadurch flüssigkeitsgekühlte Rechnereinheiten in dem Innenraum betrieben werden. Die Erfindung beruht dabei auf der Erkenntnis, dass der Einsatz eines solchen fluiden Wärmeträgers eine Vereinfachung der brandschutztechnischen Massnahmen ermöglicht, da im Brandfall nicht für eine Abdeckung der Kanalöffnungen einer Lüftungsanlage Sorge getragen werden muss.

Zur Energiesparung kann ferner eine adiabatische Kühlungseinrichtung zur Wärmerückgewinnung, insbesondere eine Ultraschall-Wasservernebelungsanlage, in dem oberen Behälterbereich angeordnet sein. Als weitere Massnahme zur Energieeinsparung ist in dem Behälter bevorzugt mindestens eine Einrichtung zur Wärmerückgewinnung angeordnet, die aus der Rückluft bzw. dem Wärmefluid, welche(s) vom Gehäuseinnenraum in den Behälterraum zurückgeführt wird, Wärme aufnimmt und an einen externen Energiespeicher weitergibt, insbesondere an einen Boiler oder an eine Wärmepumpe. Im Falle einer Flüssigkeitskühlung durch ein Wärmefluid wird vorzugsweise ein Plattenwärmetauscher zur Wärmerückgewinnung eingesetzt, der bevorzugt vor einen grossflächigeren Kühlregister zur vollständigen Abkühlung des Wärmefluids geschaltet ist.

Eine vorteilhafte Anbringung der Kühlungseinrichtung kann dadurch erreicht werden, dass der Behälter an einer Seitenwand des Gehäuses befestigt ist. Auf diese Weise kann einerseits durch die grosse Angrenzungsfläche des Behälterraums an das Gehäuse eine hochwertige Kältezuführung sichergestellt werden. Andererseits kann dadurch verhindert werden, dass aus der Kühlungseinrichtung austretende Flüssigkeiten in den Innenraum gelangen, wie dies beispielsweise bei einer oberen Anordnung der Kühlungseinrichtung auftreten könnte. Erfindungsgemäss ist zum Auffangen derartiger Flüssigkeiten, insbesondere von Kondenswasser, vorzugsweise ein Auffangbehälter unterhalb des Wärmetauschers der Kühlungseinrichtung angeordnet. In bevorzugter Ausgestaltung erstreckt sich der Behälter über mindestens zwei Drittel der Breite, vorzugsweise im Wesentlichen über die gesamte Breite, der Seitenwand, wodurch die energieeffiziente Kühlung des Innenraums weiter optimiert werden kann. Um ein Behältervolumen bereitzustellen, das eine hochwertige Klimatisierung des Gehäuseinnenraums ermöglicht, weist der Behälter vorzugsweise eine Seitenverkleidung auf, deren Breite mindestens einem Zehntel der Breite der breitesten Seitenwand des Gehäuses entspricht.

Vorzugsweise ist der Behälter derart an dem Gehäuse befestigt, dass er von dem Gehäuse mitgetragen wird. Dadurch wird neben einer einfachen Transportierbarkeit des Shelters auch ein einfaches Abnehmen und Austauschen des Behälters ermöglicht. Derart kann die Kühlungseinrichtung einschliesslich des Behälters als einfach austauschbares einheitliches Klimamodul bereitgestellt werden. Somit werden allfällige Instandsetzungsmassnahmen vereinfacht, insbesondere bei einem Defekt, einer Revision oder einer Erneuerung der Kühlungseinrichtung. Zur Befestigung an dem Gehäuse weist der Behälter bevorzugt Fixationsmittel auf, die seitlich von dem Behälterraum hervorragen. Weiter bevorzugt handelt es sich bei den Fixationsmitteln um Anhängelaschen, die ein einfaches seitliches Anbringen und Austauschen des Behälters ermöglichen. Weiterhin sind die Fixationsmittel bevorzugt luftdichtend ausgebildet.

Um eine zuverlässige Klimatisierung sicherzustellen, sind an dem Gehäuse vorzugsweise mindestens zwei Behälter zur Aufnahme jeweils einer Kühlungseinrichtung befestigt, die voneinander unabhängig zur Kältezuführung in den Innenraum ausgebildet sind. Im Normalbetrieb, bei welchem beide Kühlungseinrichtungen zur gleichen Zeit eingesetzt werden, kann dadurch eine besonders hochwertige Kühlung des Innenraums und/oder der darin angeordneten Geräte erreicht werden. Ausserdem ist damit auch ein Sonderbetrieb der Kühlung ermöglicht, bei welchem nur eine Kühlungseinrichtung zum Einsatz kommt. Beispielsweise kann derart ein Ausfall oder eine Revision einer Kühlungseinrichtung kompensiert werden, da die Kältezufuhr in den Innenraum durch die andere Kühlungseinrichtung ununterbrochen fortgesetzt werden kann.

Eine besonders vorteilhafte Verteilung der in den Innenraum zu- und rückzuführenden Luftströmung kann dadurch erreicht werden, dass die zwei Behälter an einander entgegengesetzten Aussenseiten des Gehäuses befestigt sind. Um einen voneinander unabhängigen und somit redundanten Betrieb der beiden Kühlungseinrichtungen sicherzustellen, ist jeder der Behälter bevorzugt mit jeweils einer separaten Energieversorgung verbunden.

Eine bevorzugte Ausgestaltung eines erfindungsgemässen Shelters besteht darin, dass in dem einen Behälter eine Kühlungseinrichtung mit einem Wärmetauscher zur Luftkühlung und in dem anderen Behälter eine Kühlungseinrichtung mit einem Wärmetauscher zur Flüssigkeitskühlung angeordnet ist. Ein derartiger Shelter wird bevorzugt für eine gleichzeitige Unterbringung von flüssigkeitsgekühlten und luftgekühlten Rechnereinheiten verwendet. Die gegenüberliegende Anordnung dieser unterschiedlich ausgebildeten Kühlungseinrichtungen ermöglicht eine vorteilhafte ortsnahe Unterbringung beider Klimatisierungssysteme an den zu kühlenden Komponenten. Eine bevorzugte Dimensionierung des Sheltergehäuses resultiert in einem Innenraum, der für Personen als Arbeitsstätte ungeeignet ist, insbesondere nur beschränkt begehbar ist. Bei einem solchen einfach transportierbaren und verlustarm klimatisierbaren Shelter beträgt die Breite der breitesten Seitenwand des Gehäuses höchstens drei Meter, weiter bevorzugt höchstens zwei Meter. Durch die so gewählte Dimensionierung des Gehäuses kann insbesondere eine homogene Temperaturverteilung innerhalb des klimatisierten Innenraums sichergestellt werden, um die darin untergebrachten Apparate oder Wertgegenstände nicht zu schädigen. Erfindungsgemäss können ein oder mehrere derartige Shelter in einem Raum untergebracht werden, wodurch die aufzuwendende Kühlenergie auf das zu kühlende Teilvolumen des Raumes beschränkt bleibt und Energieverluste gering gehalten werden. Neben den einfach transportierbaren Sheltern sind dabei auch Shelter denkbar, die fest im Raum verankert sind.

Ein derart dimensionierter Shelter umfasst bevorzugt mindestens eine Zugangstür, wobei die Seitenwände zur seitlichen Begrenzung des Innenraums jeweils um nicht mehr als doppelt so breit sind wie die Breite der Zugangstür. Vorzugsweise weist die Zugangstür die Abmessungen einer Personentür auf, um ein komfortables Einbringen von Gegenständen in den Innenraum zu erlauben. Insbesondere erstreckt sich die Zugangstür vorzugsweise über die gesamte Breite der Seitenwand mit der Zugangstür. Auf diese Weise können sowohl in klimatisierungstechnischer als auch brandschutztechnischer Hinsicht hohe Anforderungen erfüllt werden und gleichzeitig ist eine hohe Transportfähigkeit des Shelters ermöglicht.

Um ein einfaches Einbringen der gewünschten Einbauten zu ermöglichen, ist vorzugsweise eine zweite Zugangstür an der entgegengesetzten Seitenwand vorhanden. Beispielsweise kann dadurch die von den Seitenwänden begrenzte Breite des Innenraums für das Einschieben von 19 Zoll-Einheiten, insbesondere Computerservern, optimiert sein. Durch den zweiten Zugang kann insbesondere für die Vernetzung und Verkabelung der Einbauten gesorgt werden. Zudem können auch in der Dachwandung des Gehäuses Durchbrüche vorhanden sein, um für eine Zugängigkeit der Verkabelung zu sorgen, insbesondere zur Leitungs- und Kabeldurchführung. Dabei handelt es sich vorzugsweise um brand- und wasserschutztechnisch einfach zuschottbare Öffnungen.

Neben einer Unterbringung von hochempfindlichen technischen Geräten ist der vorangehend beschriebene Shelter auch zur geschützten Verwahrung von anderen umgebungsempfindlichen Objekten einsetzbar. Aufgrund der hochwertigen und sicheren Klimatisierung in Verbindung mit einem hohen Brandschutz und/oder Einbruchschutz ist der Shelter insbesondere zur Aufbewahrung von Kunstobjekten, Bibliotheks-, Archiv-, Museumsgütern und ähnlichen Wertgegenständen geeignet.

Nachfolgend ist die Erfindung anhand bevorzugter Ausführungsformen unter Bezugnahme auf die Zeichnungen näher erläutert, anhand welchen sich weitere Eigenschaften und Vorteile der Erfindung ergeben. Die Figuren, die Beschreibung und die Ansprüche enthalten zahlreiche Merkmale in Kombination, die der Fachmann auch einzeln betrachten und zu sinnvollen weiteren Kombinationen zusammenfassen wird. Dabei zeigen:
- Fig. 1:: eine perspektivische Aussenansicht eines transportierbaren Shelters;
- Fig. 2:: eine Querschnittsansicht des in Fig. 1 gezeigten Shelters entlang einer parallel zu den seitlich befestigten Klimamodulen verlaufenden Schnittebene;
- Fig. 3:: eine Explosionsdarstellung des in Fig. 1 gezeigten Shelters;
- Fig. 4:: eine zum Teil ausgebrochene perspektivische Darstellung eines Klimamoduls gemäss einer ersten Ausführungsform für den in Fig. 1 gezeigten Shelter;
- Fig. 5:: eine zum Teil ausgebrochene perspektivische Darstellung eines Klimamoduls gemäss einer zweiten Ausführungsform für den in Fig. 1 gezeigten Shelter;
- Fig. 6:: eine zum Teil ausgebrochene perspektivische Darstellung eines Klimamoduls gemäss einer dritten Ausführungsform für den in Fig. 1 gezeigten Shelter;
- Fig. 7:: eine Querschnittsansicht des in Fig. 1 gezeigten Shelters gemäss einer ersten Ausführungsform entlang einer senkrecht zu den seitlich befestigten Klimamodulen verlaufenden Schnittebene;
- Fig. 8:: eine Querschnittsansicht eines Shelters gemäss einer zweiten Ausführungsform entlang einer senkrecht zu dem seitlich befestigten Klimamodul verlaufenden Schnittebene; und
- Fig. 9:: eine Querschnittsansicht eines Shelters gemäss einer dritten Ausführungsform entlang einer senkrecht zu dem seitlich befestigten Klimamodul verlaufenden Schnittebene.

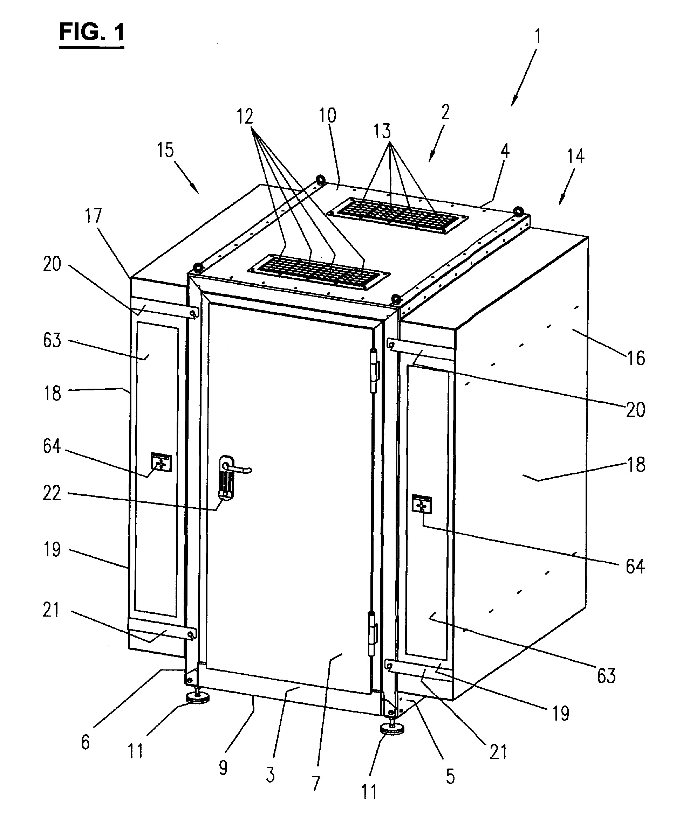

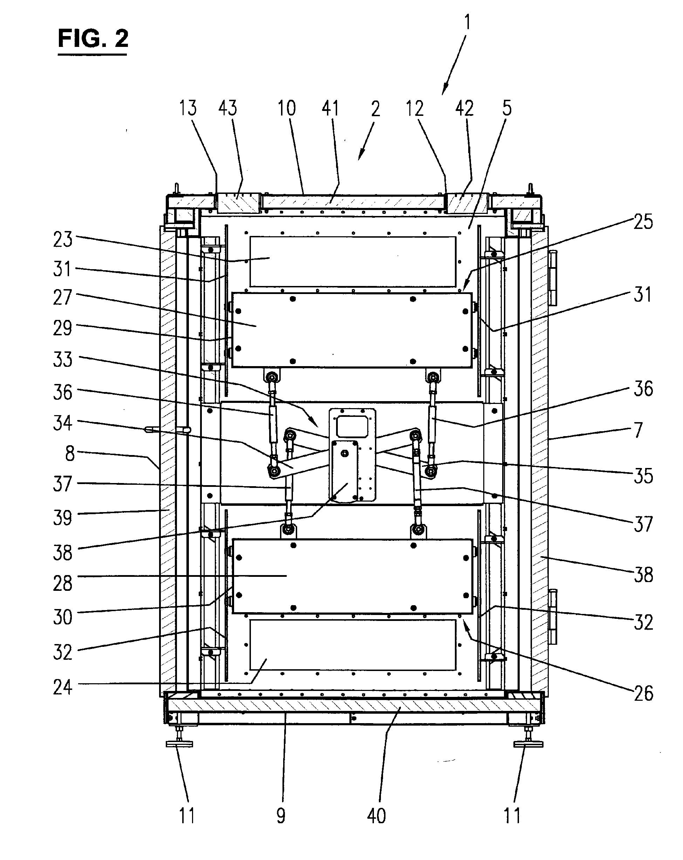

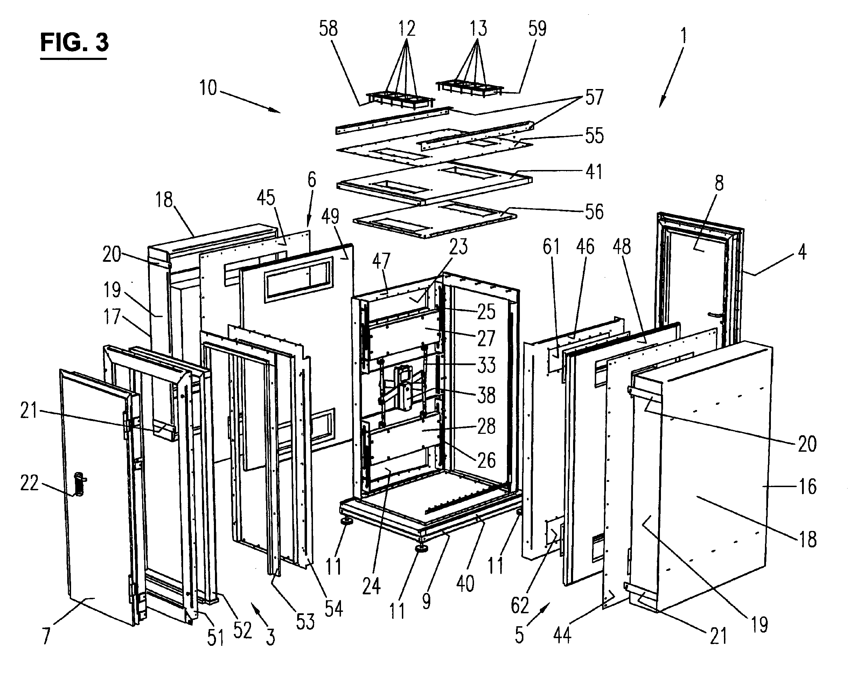

Die Fig. 1 zeigt einen Shelter 1 mit einem quaderförmigen Gehäuse 2 zur Begrenzung eines klimatisierbaren Innenraums. Die vordere Seitenwand 3 des Gehäuses 2 ist nur geringfügig grösser als eine darin angeordnete Zugangstür 7. Eine weitere identisch ausgebildete Zugangstür 8 ist (wie in Figg. 2 und 3 erkennbar ist) in der entgegengesetzten hinteren Seitenwand 4 angeordnet. Die Breite der beiden lateralen Seitenwände 5, 6 ist weniger als doppelt so gross wie die Breite der vorderen und hinteren Seitenwände 2, 4. Zum Zweck einer hohen Transportfähigkeit des Shelters 1 und zur Bereitstellung eines verlustarm und homogen klimatisierbaren Innenraums weisen die Seitenwände 3-6 eine maximale Breite von höchstens zwei Metern auf.

Die Zugangstüren 7, 8 weisen im Wesentlichen die Abmessungen von Personentüren auf, so dass dadurch ein Zugang für Personen ermöglicht ist. Allerdings ist aufgrund der Dimensionierung des Gehäuses 2 der dadurch begrenzte Innenraum als längerer Aufenthaltsort oder als Arbeitsumgebung für Personen ungeeignet. Somit erfüllen die Zugangstüren 7, 8 vorwiegend die Funktion von Gerätetüren zum einfachen Einbringen der im Innenraum des Gehäuses 2 unterzustellenden Wertgegenstände. Beispielsweise können dadurch 19 Zoll-Rechnereinschübe von herkömmlichen IT-Racks bequem in den Innenraum eingebracht werden. Durch die beidseitige Anordnung der Zugangstüren 7, 8 ist zudem eine bequeme Anschlussmöglichkeit an Stromnetze und andersartige Netzversorgungen für die eingebrachten Geräte geschaffen.

Die untere Bodenwand 9 des Gehäuses 2 wird an ihren vier Eckbereichen von jeweils einem höhenverstellbaren Tragfuss 11 getragen. Die Tragfüsse 11 sind mit jeweils einem Schwingungsdämpfer ausgestattet. Die obere Deckenwand 11 des Gehäuses 2 weist im Bereich ihrer Vorderkante und ihrer Hinterkante jeweils eine Mehrzahl von leicht zuschottbaren Öffnungen 12, 13 auf, die für eine brand- und wasserschutztechnische Leitungs- und Kabeldurchführung geeignet sind.

An den beiden entgegengesetzten lateralen Seitenwänden 5, 6 ist jeweils ein Klimamodul 14, 15 befestigt. Die zwei Klimamodule 14, 15 umfassen jeweils einen Behälter 16, 17 in welchem jeweils eine Kühlungseinrichtung zur Kältezuführung in den vom Gehäuse 2 begrenzten Innenraum untergebracht ist. Die identisch ausgebildeten Behälter 16, 17 weisen jeweils eine rechteckige Rückwand 18 auf. Entlang allen vier Kanten der Rückwand 18 verläuft mit konstanter Breite eine Seitenverkleidung 19 des Behälters 16, 17. Derart ist durch die Rückwand 18 und die Seitenverkleidung 19 des Behälters 16, 17 und die daran angrenzende laterale Seitenwand 5, 6 des Gehäuses 2 ein jeweils quaderförmiger Behälterraum zur Aufnahme jeweils einer Kühlungseinrichtung abgegrenzt. Die Breite der Seitenverkleidung 19 entspricht etwa einem Fünftel der Breite der breitesten Seitenwand 5, 6 des Gehäuses 2. Das dadurch bereitgestellte Behältervolumen ermöglicht insbesondere eine hervorragende Klimatisierung des Gehäuseinnenraums.

Durch die Behälter 16, 17 ist die darin angeordnete Kühlungseinrichtung von der äusseren Umgebung des Shelters 1 im Wesentlichen vollständig abgedeckt. Zur luftdichten Isolierung des Behälterraums von der Aussenumgebung des Shelters 1 weisen die Behälter 16, 17 zumindest entlang ihres an das Gehäuse 2 angrenzenden Umfangs ein flexibles temperaturbeständiges Isolierband auf. Zudem ist die Innenwandung der Behälter 16, 17 mit nicht brennbaren Thermo- und Schallisolationsmatten ausgestattet.

Die Breite der Rückwand 18 der Behälter 16, 17 entspricht im Wesentlichen der Breite der lateralen Seitenwände 5, 6 des Gehäuses 2. Auf diese Weise lässt sich eine optimale Klimatisierung des Innenraums des Gehäuses 2 sicherstellen. Die Höhe der Behälter 16, 17 ist etwas kleiner als die Höhe der Gehäuseseitenwände 5, 6. Dadurch ergibt sich ein oberer und unterer freiliegender Flächenabschnitt der lateralen Seitenwände 5, 6.

Im oberen und im unteren Bereich der Seitenverkleidung 19 der Behälter 16, 17 sind jeweils vorne und hinten Anhängelaschen 20, 21 vorgesehen, die ein einfaches seitliches Anbringen und Austauschen des jeweiligen Behälters 16, 17 an dem Gehäuse 2 ermöglichen. Die Anhängelaschen 20, 21 dienen zur luftdichten Fixierung der Behälter 16, 17 an dem Gehäuse 2. Zu diesem Zweck können die Anhängelaschen 20, 21 mit einem Isolationsband versehen sein. Ausserdem können zusätzliche Anhängelaschen auch an einem anderen Höhenbereich des Behälters 16, 17 angebracht sein, um die Fixation und/oder die Isolationswirkung zu verstärken.

Der vordere Bereich der Seitenverkleidung 19 umfasst jeweils einen Öffnungsdeckel 63, der beispielsweise bei einem beabsichtigten Filterwechsel oder einer Revision der Kühlungseinrichtung einen Zugang zu dem Behälterraum erlaubt. An der Innenseite des Öffnungsdeckels ist eine Steuer-/ und Regulierungseinheit für die Kühlungseinrichtung im Behälterraum befestigt, sowie eine Überwachungseinheit, die insbesondere zur Wasserdetektion, Klima- und Raumüberwachung ausgebildet ist. Vorzugsweise sind diese elektronischen Bestandteile des Öffnungsdeckels 63 hermetisch vom Behälterraum abgedichtet. An der Vorderseite des Öffnungsdeckels 63 ist jeweils eine Anzeige- und/oder Eingabeeinrichtung 64 befestigt. Dadurch kann beispielsweise ein Ablesen oder eine Eingabe von sicherheitsrelevanten Daten bezüglich der Kühlungseinrichtungen oder des Gehäuseinnenraums ermöglicht werden.

Im äusseren Bereich eines Türgriffs der Zugangstüren 7, 8 ist ein manuelles Eingabegerät 22, insbesondere ein Tastaturblock mit einem Display, angeordnet. Vorzugsweise umfasst das Eingabegerät 22 eine Einrichtung zur Zutrittskontrolle zum Gehäuseinnenraum, insbesondere einen biometrischen Fingerscanner.

Eine derartige Konstruktion eines Shelters 1 ermöglicht einerseits eine einfache Transportierbarkeit des Shelters 1, insbesondere auf einem Transportfahrzeug, Kran, Paletthubwagen oder dergleichen. Andererseits wird dadurch ein autark arbeitender Schutzraum bereitgestellt, der zur freien Aufstellung in Gebäudeinnenräumen geeignet ist und dennoch einen hochwertigen Schutz für umgebungsempfindliche Gegenstände, insbesondere gegen Feuer, Wasser, korrosive Rauchgase, elektromagnetische Strahlungsfelder (EMP), Vandalismus, Sabotage und Diebstahl, liefern kann. Durch die vorteilhafte Bemessung des Shelters 1 wird zudem eine optimale Klimatisierung der darin befindlichen Einbauten auf energiesparende Weise ermöglicht. Dies wird insbesondere erreicht durch die ortsnahe Unterbringung der Klimamodule 14, 15 an dem zu klimatisierenden Innenraum des Gehäuses 2 und durch die beschränkte räumliche Ausdehnung dieses Innenraums, wodurch eine unbenötigte Klimatisierung ungenutzten Raumvolumens gering gehalten wird.

In Fig. 2 ist eine Frontansicht der lateralen Seitenwand 5 des Gehäuses 2 von der Innenraumseite her dargestellt. Die Seitenwand 5 umfasst eine deckenseitige Rückluftkanalöffnung 23 und eine bodenseitige Zuluftkanalöffnung 24, durch welche der Innenraum des Gehäuses 2 mit dem aussenseitigen Behälterraum in Verbindung steht. Die Kanalöffnungen 23, 24 erstrecken sich über mehr als zwei Drittel der Breite der Seitenwand 5, um eine gute Belüftbarkeit des Innenraums zu ermöglichen.

Vor der lateralen Seitenwand 5 ist unterhalb der Rückluftkanalöffnung 23 und oberhalb der Zuluftkanalöffnung 24 jeweils ein Schutzschieber 25, 26 angeordnet. Die Schutzschieber 25, 26 sind jeweils durch eine feuerfeste Materialschicht 27, 28 gebildet, insbesondere eine hochgradig brandisolierende Kalziumsilikatplatte, die in einen rostfreien Stahlrahmen 29, 30 eingefasst ist. Die Abdeckfläche der Schutzschieber 25, 26, welche durch die Oberfläche der feuerfesten Materialschicht 27, 28 gebildet ist, ist grösser als die Oberfläche der jeweils zugeordneten Kanalöffnung 23, 24. Entlang seitlich angeordneter Führungsschienen 31, 32 sind die Schutzschieber 25, 26 zwischen einer Offenstellung und einer Verschlussstellung der Kanalöffnungen 23, 24 verschiebbar gelagert. In der Verschlussstellung der Schutzschieber 25, 26 ist der Grenzbereich zwischen dem Behälterraum und dem Gehäuseinnenraum an den Kanalöffnungen 23, 24 vollständig von der feuerfesten Materialschicht 27, 28 abgedeckt. Zwischen den Schutzschiebern 25, 26 ist eine Hebelanordnung 33 mit zwei sich überkreuzenden Hebelstangen 34, 35 angeordnet. Durch jeweils zwei Verbindungsstangen 36, 37 sind die Schutzschieber 25, 26 an jeweils beide Hebel 34, 35 angelenkt. Auf diese Weise erfolgt eine gegenseitige Gewichtskompensation der beiden Schutzschieber 25, 26 über die Hebelanordnung 33. Trotz ihres recht hohen Gewichts können die Schutzschieber 25, 26 somit mit relativ geringem Kraftaufwand zwischen der Offenstellung und der Verschlussstellung der Kanalöffnungen 23, 24 verschoben werden.

Zur Aktivierung des Verschiebungsmechanismus der beiden Schutzschieber 25, 26 über die Hebelanordnung 33 ist im Überkreuzungsbereich der Hebelstangen 34, 35 eine Aktivierungseinheit 38 montiert. Die Aktivierungseinheit 38 enthält einen Federrücklaufantrieb mit einer Feder zum Übertragen eines Drehmoments auf die Hebelanordnung 33, wodurch die Schutzschieber 25, 26 von der Offenstellung in die Verschlussstellung der Kanalöffnungen 23, 24 verschoben werden können. Der Federrücklaufantrieb umfasst ausserdem einen Motor zum Aufziehen der Feder, wodurch die Schutzschieber 25, 26 von der Verschlussstellung in die Offenstellung der Kanalöffnungen 23, 24 zurückgeführt werden können. Die Aktivierungseinheit 38 wird im Brandfall beispielsweise durch ein thermoelektrisches Signal oder einen Stromausfall ausgelöst.

Weitere technische Merkmale und Vorteile der voranstehend beschriebenen Brandschutzvorrichtung mit den Schutzschiebern 25, 26 für die Kanalöffnungen 23, 24 sind der EP 2 030 651 A1 des gleichen Anmelders entnehmbar.

Die beiden Zugangstüren 7, 8, sowie die Bodenwand 9 und die Deckenwand 10 weisen entlang ihrer gesamten Erstreckungsfläche jeweils eine feuerfeste Materialschicht 38-41 auf, die jeweils durch eine hochgradig brandschutzsichere Kalziumsilikatplatte gebildet ist. Zudem sind die Öffnungen 12, 13 in der Deckenwand 10 durch eine solche feuerfeste Materialschicht 42, 43 zugeschottet.

In der Explosionsdarstellung des Shelters 1 gemäss Fig. 3 ist der modulare Aufbau der Gehäusewände 3-6, 9, 10 genauer erkennbar. Die lateralen Seitenwände 5, 6 umfassen jeweils eine Aussenwandverkleidung 44, 45, eine Innenwandverkleidung 46, 47 und eine dazwischen angeordnete feuerfeste Materialschicht 48, 49. In all diesen Bestandteilen 44-49 der Seitenwände 5, 6 sind einander entsprechende Durchbrüche für die Kanalöffnungen 23, 24, 61, 62 vorhanden. Die zwei Kanalöffnungen 61, 62 der rechten Seitenwand 5 weisen die gleichen Abmessungen wie die zwei Kanalöffnungen 23, 24 der linken Seitenwand 6 auf und befinden sich an der entsprechenden gegenüberliegenden Position.

Die Aussenwandverkleidungen 44, 45 und die Innenwandverkleidungen 46, 47 bestehen jeweils aus einer Platte aus rostfreiem Stahl, die selbsttragend ausgebildet ist. Die feuerfeste Materialschicht 48, 49 ist an ihrer unteren Aussenkante an Stützträgern befestigt, so dass auch der zwischen der Aussenwandverkleidung 44, 45 und Innenwandverkleidung 46, 47 vorhandene Bestandteil der Seitenwände 5, 6 selbsttragend ausgebildet ist. Bei den Stützträgern handelt es sich um C-förmige Stahlträger, die auf der Bodenwand 9 angeordnet sind. Die feuerfeste Materialschicht 48, 49 besteht jeweils aus einer hochgradig brandisolierenden Kalziumsilikatplatte. Durch die selbsttragende Aussenwandverkleidung 44, 45 und Innenwandverkleidung 46, 47 erfährt die feuerfeste Materialschicht 48, 49 eine zusätzliche Abstützung. Durch die drei ineinander verschachtelten selbsttragenden Materialschichten, welche durch die Innenschicht 46, 47, die Zwischenschicht 48, 49 und die Aussenschicht 44, 45 gebildet sind, ist eine hohe Stabilität der Shelterkonstruktion selbst bei einem Brandfall und teilweisem Wegschmelzen der Seitenwände 5, 6 gewährleistet. Weiterhin ergibt sich dadurch eine hohe Einbruchsicherheit in den Innenraum des Gehäuses 2.

Durch die feuerfesten Materialschichten 48, 49 ist ein statischer feuerfester Abschnitt 48, 49 gebildet, der ortsfest in einem Grenzbereich zwischen dem Behälterraum und dem Innenraum des Gehäuses 2 angeordnet ist. Zusammen mit dem aktivierbaren feuerfesten Abschnitt 27, 28 der Schutzschieber 25, 26 lässt sich somit ein Grenzbereich zwischen dem Behälterraum und dem Gehäuseinnenraum vollständig brandschützend abdecken.

Die vordere und hintere Seitenwand 3, 4 besteht aus der Zugangstür 7, 8 und einer vierteiligen Rahmenkonstruktion 51-54. Die Rahmenkonstruktion umfasst eine feuerfeste Materialschicht 52 aus Kalziumsilikat, die zwischen Stahlrahmen 51, 53, 54 angeordnet ist.

Die feuerfeste Materialschicht 41 der Deckenwand 10 ist entlang ihrer oberen und unteren Oberfläche durch jeweils eine Wandverkleidung 55, 56 aus rostfreiem Stahl abgedeckt und durch zwei Seitenschienen 57 daran befestigt. Die einzelnen brandschützend abschottbaren Öffnungen 12, 13 sind durch zwei Einsatzteile 58, 59 in dafür vorgesehene Durchbrüche in den Wandverkleidungen 55, 56 und der feuerfesten Materialschicht 41 gebildet.

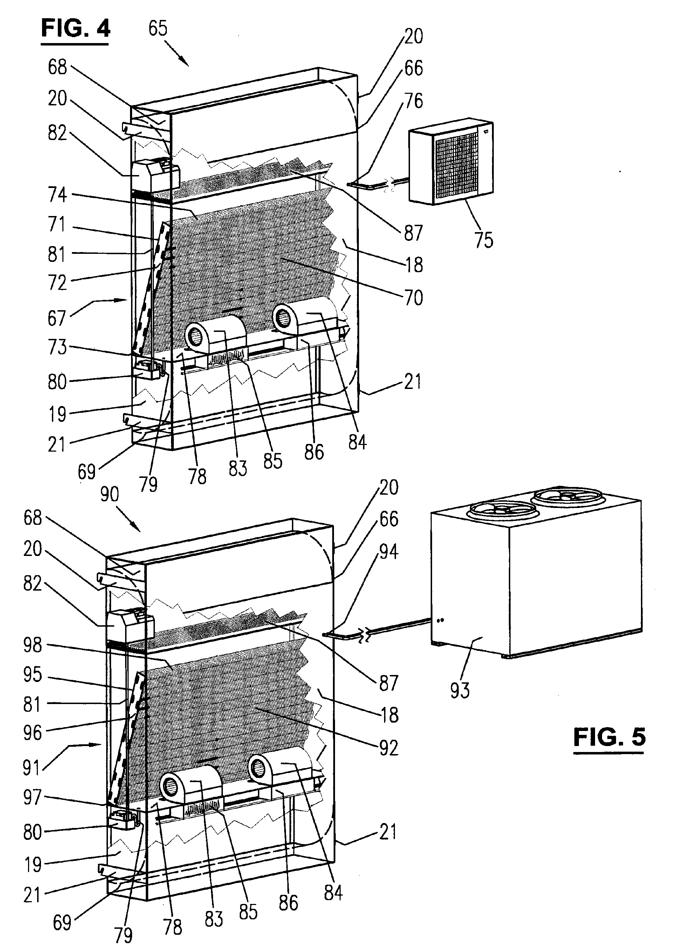

Die Fig. 4 zeigt ein Klimamodul 65 gemäss einer ersten Ausführungsform, welches als Klimamodul 14, 15 des voranstehend beschriebenen Shelters 1 eingesetzt werden kann. Hierzu weist das Klimamodul 65 einen Behälter 66 zur Aufnahme einer Kühlungseinrichtung 67 auf, der die gleichen Merkmale wie die voranstehend beschriebenen Behälter 16, 17 aufweist. Im oberen Bereich des Behälterraums ist ein gebogenes Rückluftablenkblech 68 und im unteren Bereich ein gebogenes Zuluftablenkblech 69 angeordnet, welche zur Umleitung des Luftströmungswegs weg von der Rückluftkanalöffnung 23 und hin zu der Zuluftkanalöffnung 24 dienen. Die Ablenkbleche 68, 69 erstrecken sich im Wesentlichen über die gesamte Breite der Rückwand 18 und der Seitenverkleidung 19 des Behälters 66, um dadurch eine energiesparende und optimale Durchströmung des Behälterraums zu erreichen. Insbesondere wird dadurch eine Reduzierung des gegen aussen wirkenden Drucks und somit ein geringerer Stromverbrauch für eine Ventilationseinrichtung 83, 84 erreicht.

Die Kühlungseinrichtung 67 umfasst einen Wärmetauscher in Form eines Kühlregisters 70, der im Zentralbereich des Behälters 66 angeordnet ist und sich über etwa ein Drittel der Behälterhöhe und im Wesentlichen die gesamte Breite des Behälterraums erstreckt. Der Wärmetauscher 70 ist zudem in dem Behälterraum derart schräg gestellt, dass seine Seitenkanten 72 sich im Wesentlichen über die vollständige Breite der Seitenverkleidung 19 erstrecken. Auf diese Weise ist eine optimale Ausnutzung der Oberfläche 71 des Wärmetauschers 70 durch die saugende Anordnung einer Ventilationseinrichtung 83, 84 in dem geschlossenen Lüftungskreislauf zwischen Gehäuseinnenraum und Behälterraum sichergestellt.

Bei dem Wärmetauscher 70 handelt es sich um einen Lamellenwärmetauscher, der eine Verdampfereinheit bildet und mit einer ausserhalb vom Behälterraum angeordneten Kompressionskältemaschine 75 in Verbindung steht. Die Verbindung erfolgt durch Steckkopplungen 76, die aus der Rückwand 18 des Behälters herausragen. Die Kompressionskältemaschine 75 umfasst einen Verdichter und einen Verflüssiger zur Komprimierung und Kondensierung des zur Kühlung der Verdampfereinheit 70 benötigten Kältemittels. Vorzugsweise wird hierzu ein umweltneutrales Kältemittel eingesetzt. Anstelle einer Auf/Zu-Ventilschaltung ist in der Flüssigkeitsleitung vor dem Wärmetauscher (Verdampfer) 70 ein mikromotorbetriebenes Einspritzventil 77 eingebaut, welches zur Energiesparung beiträgt. Das Einspritzventil 77 wird über einen Datenbus in Abhängigkeit vom Kühlbedarf zusammen mit dem drehzahlgesteuerten Verdichter 70 stetig geregelt.

Entlang der Unterkante 73 des Wärmetauschers 70 ist eine Kondensatsammelwanne 78 angeordnet. Die Kondensatsammelwanne 78 ist zur Abführung des darin angesammelten Kondenswassers über einen Syphon 79 mit einem aussenseitig darunterliegenden Kondenswasserbehälter 80 verbunden. Der Kondenswasserbehälter 80 umfasst eine Pumpe und ein Rücklaufsperrventil. Durch eine Vertikalleitung 81 ist der Kondenswasserbehälter 80 mit einem im oberen Behälterbereich angeordneten Ultraschallvernebler 82 verbunden. Auf diese Weise kann das im Kondenswasserbehälter 80 angehäufte Kondenswasser zum Ultraschallvernebler 82 hochgepumpt werden und dort durch Kavitation, insbesondere mittels Schwingungen eines Piezokristalls, zerstäubt werden. Das zerstäubte Kondenswasser wird vom Ultraschallvernebler 82 in den Lüftungskreislauf zurückgeführt und trägt dadurch auf energiesparende Weise zur Erhöhung der Kühlleistung bei.

Die Schrägstellung des Wärmetauschers 70 in dem Behälter 66 ist derart gewählt, dass die zuluftseitige Unterkante 73 einen grösseren Abstand von der Rückwand 18 aufweist als die rückluftseitige Oberkante 74. In dem dadurch gebildeten Zwischenraum zwischen der Rückwand 18 und dem unteren Flächenabschnitt des Wärmetauschers 70 befinden sich zwei oder mehr Ventilatoren 83, 84. Die Ansaugseite der Ventilatoren 83, 84 ist somit ortsnah an der Rückseite des Wärmetauschers 70 angeordnet, was zur leistungsoptimierten Nutzung der Gesamtoberfläche des Wärmetauschers 70 beiträgt. Weiterhin ergibt sich dadurch eine vorteilhafte Anordnung der Ventilatoreinrichtung 83, 84 nahe an der Rückwand 18, wodurch eine optimale Verteilung der erzeugten Luftströmung innerhalb des Behälterraums erreicht wird. Daraus resultiert eine hervorragende Belüftung des Shelters 1 auf energiesparende Weise. Vorzugsweise ist die Drehzahl der Ventilatoren 83, 84 steuerbar und in Abhängigkeit der benötigten Kühlleistung einstellbar.

An der Druckseite der Ventilatoren 83, 84 im unteren Behälterbereich befindet sich jeweils ein Feinstaubfilter 85, 86. Die Feinstaubfilter 85, 86 weisen eine Aktivkohlebeschichtung auf, wodurch insbesondere Staubpartikel, korrosive Dämpfe und Gase von der aus dem Behälterraum abzuführenden Zuluft herausgefiltert werden.

Eine grobe Staubfilterung der in den Behälterraum eintretenden Rückluft wird bereits durch einen Grobstaubfilter 87 erreicht, der im oberen Behälterbereich zwischen dem Ultraschallvernebler 82 und dem Wärmetauscher 70 angeordnet ist. Der Grobstaubfilterhalter 87 ist ein Kassetten-Grobstaubfilter, der einen Filterhalter und austauschbare Filterelemente umfasst. Der Grobstaubfilter 87 ist im Wesentlichen plattenförmig ausgebildet und mit grossen Luftaustrittsöffnungen versehen. Er erstreckt sich in horizontaler Richtung über den gesamten Behälterquerschnitt. Auf diese Weise wird zusätzlich die Verwindungsstabilität des Behälters 66 erhöht.

Durch den Filterhalter des Grobstaubfilters 87 und die plattenförmige Kondenssammelwanne 78 ist der Behälterraum entlang seiner Höhe in drei Volumenabschnitte getrennt. Der obere Volumenabschnitt dient zur Aufnahme der warmen Rückluft, der mittlere Volumenabschnitt enthält die filtrierte und eventuell befeuchtete Rückluft und der untere Volumenabschnitt dient zur Abgabe der gekühlten Zuluft. Zur luftdichten Isolierung dieser Volumenabschnitte voneinander ist im vorderen Kantenbereich der an das Sheltergehäuse 2 angrenzenden Platten 78, 87 jeweils ein Isolationsband angeordnet.

Die Fig. 5 zeigt ein Klimamodul 90 gemäss einer zweiten Ausführungsform, welches als Klimamodul 14, 15 des voranstehend beschriebenen Shelters 1 eingesetzt werden kann. Das Klimamodul 90 ist in konstruktiver Hinsicht identisch zu dem voranstehend beschriebenen Klimamodul 65 ausgebildet, mit dem Unterschied, dass bei der darin untergebrachten Kühlungseinrichtung 91 ein Wärmetauscher in Form eines Kühlregisters 92 zum Einsatz kommt, dessen Kühlungsfluid von einem Kaltwassersatz 93 zur Verfügung gestellt wird.

Der Kaltwassersatz 93 befindet sich ausserhalb des Behälters 66 des Klimamoduls 90 und ist durch entsprechende Steckkopplungen 94, die aus der Rückwand 18 des Behälters 66 herausragen, mit den Kühlungsmittelleitungen des kaltwasserbetriebenen Wärmetauschers 92 verbunden. Vorzugsweise ist der Kaltwasserkreislauf für einen energiesparenden Betrieb mit Komponenten zur Energiesparung ausgestattet, insbesondere einer Einrichtung zur Kühlung des Fluids ohne Einschaltung der Kältekompressionsmaschine("free-cooling") durch die Nutzung der Aussentemperatur, insbesondere unterhalb 12° Celsius.

Der Wärmetauscher 92 ist ein Lamellenwärmetauscher und erstreckt sich ebenfalls etwa über das mittlere Drittel der Höhe des Behälters 66 und ist derart schräggestellt, dass seine zuluftseitige Unterkante 97 einen grösseren Abstand von der Rückwand 18 aufweist als seine rückluftseitige Oberkante 98. Dabei erstrecken sich die Seitenkanten 69 des Wärmetauschers 92 im Wesentlichen über die vollständige Breite der Seitenverkleidung 19. Dadurch wird in der gleichen Weise wie bei dem voranstehend beschriebenen Klimamodul 65 die Oberfläche 95 des Wärmetauschers 92 optimal eingesetzt. Zudem wird durch die im Bereich der Unterkante 97 vorhandenen Ventilatoren 83, 84 eine vorteilhafte Verteilung der Luftströmung innerhalb des vorhandenen Behälterraums erzielt. Zur Energiesparung trägt ausserdem die insgesamt grossflächige Auslegung des Wärmetauschers 92 bei, so dass vorzugsweise Kaltwasser mit einer Temperatur oberhalb des Taupunkts eingesetzt werden kann, um latente Verluste, beispielsweise durch Wasserausscheidung, auszuschliessen.

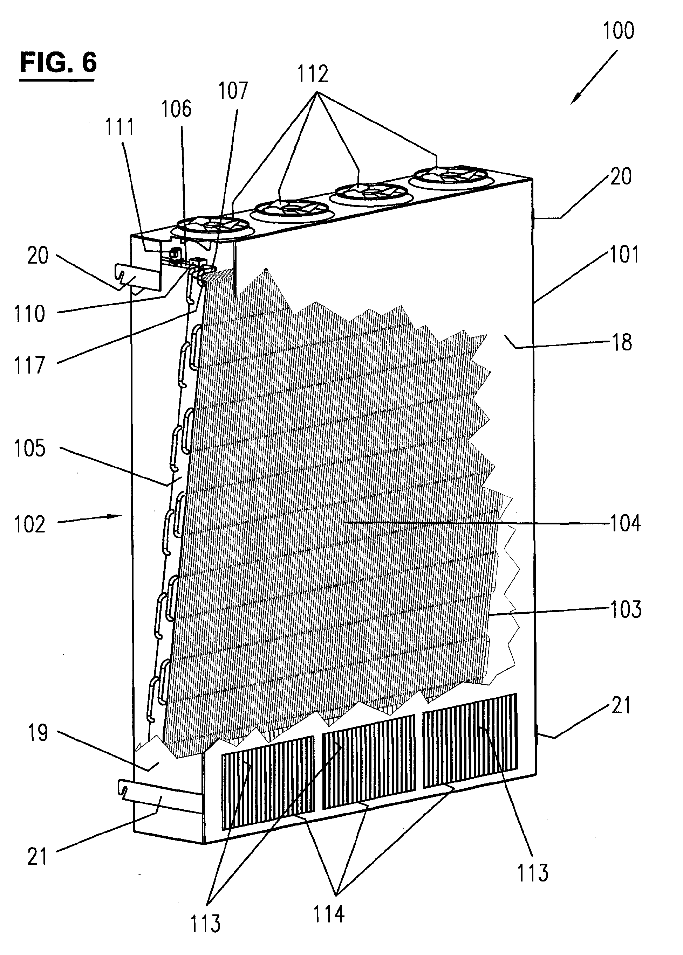

Die Fig. 6 zeigt ein Klimamodul 100 gemäss einer dritten Ausführungsform, welches als Klimamodul 14, 15 des voranstehend beschriebenen Shelters 1 eingesetzt werden kann. Das Klimamodul 100 unterscheidet sich im Hinblick auf die voranstehend beschriebenen Klimamodule 65, 90 sowohl durch seinen Behälter 101 als auch durch die darin untergebrachte Kühlungseinrichtung 102. Im Wesentlichen identisch ausgebildete Einzelbestandteile sind jedoch mit dem gleichen Bezugszeichen versehen.

Die Kühlungseinrichtung 102 umfasst einen Lamellenwärmetauscher 103 der sich im Wesentlichen über die gesamte Höhe des Behälters 101 erstreckt. Zur weiteren Optimierung der für den Wärmetausch verfügbaren Oberfläche 104 ist der Wärmetauscher 103 in dem Behälterraum schräggestellt. Dabei weist seine Unterkante 116 einen grösseren Abstand von der Rückwand 18 auf als seine Oberkante 117. Die Seitenkanten 105 des Wärmetauschers 103 erstrecken sich im Wesentlichen über die Gesamtbreite der Seitenverkleidung 19 des Behälters 101.

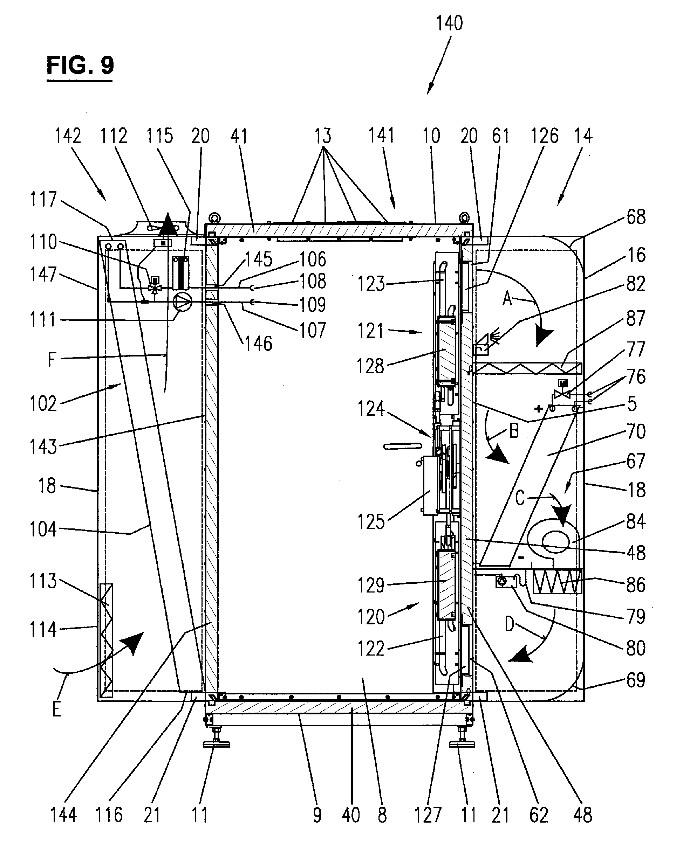

Der Wärmetauscher 103 wird als Kühlkörper für eine Flüssigkeitskühlung eingesetzt. Vorzugsweise handelt es sich dabei um einen Lamellenwärmetauscher 103. Beispielsweise kann der Wärmetauscher 103 an Rechnereinheiten mit wassergekühlten Mikroprozessoren angeschlossen werden. Zu diesem Zweck verlaufen Leitungen 106, 107 zur Flüssigkeitszuführung und zur Flüssigkeitsrückführung zwischen der Vorderseite des Behälters 101 und dem Wärmetauscher 103. Die Flüssigkeitsleitungen 106, 107 sind im oberen Behälterbereich angeordnet. An ihrem vorderen Ende weisen die Leitungen 106, 107 jeweils eine Anschlusskopplung 108, 109 auf (wie in Fig. 9 ersichtlich ist), insbesondere zum Anschliessen an einen im Innenraum des Sheltergehäuses 2 befindlichen Flüssigkeitsverteiler. Ausserdem sind die Leitungen 108, 109 mit einem Mischventil 111 zum Konstanthalten der Flüssigkeitstemperatur ausgestattet. Zum Durchführen der Kühlungsflüssigkeit in dem Leitungskreislauf 106, 107 wird eine Umwälzpumpe 110 verwendet.

In der Leitung 106 zur Flüssigkeitsrückführung ist vor dem Eingang in den Lamellenwärmeaustauscher 103 ein Platten-Wärmetauscher 115 angeordnet, wie in Fig. 9 näher ersichtlich ist. Der Platten-Wärmetauscher 115 wird vorzugsweise zur Wärmerückgewinnung eingesetzt, beispielsweise zum Aufheizen eines Boilers oder zur Wärmeabgabe an eine Wärmepumpe.

An der Oberseite des Gehäuses 101 sind mehrere Ventilatoren 112 angeordnet. Die Ventilatoren 112 werden vorzugsweise nur dann eingesetzt, wenn in dem Behälterraum überschüssige warme Luft erzeugt wird, die nicht durch die Wärmerückgewinnung über den Platten-Wärmetauscher 115 kompensiert werden kann, oder wenn überschüssige Wärme vorhanden ist, die von den externen Verbrauchern nicht mehr aufgenommen werden kann, so dass die Temperatur im Fluid-Vorlauf einen Soll-Wert übersteigt. Zur Optimierung der Kühlleistung befindet sich die Ansaugseite der Ventilatoren 112 in der Nähe des Eingangs der Leitung 106 zur Flüssigkeitsrückführung in den Lamellen-Wärmetauscher 103. Ferner weisen die Ventilatoren 112 bevorzugt eine kühlleistungsabhängige Drehzahlsteuerung auf. Im unteren Bereich der Rückwand 18 des Gehäuses 101 sind mit Staubfiltern 113 versehene Öffnungen 114 vorhanden, die zur Zuführung der kühlenden Umgebungsluft in den Behälterraum dienen.

Durch die beschriebenen Klimamodule 65, 90, 100 sind die zur Klimatisierung wesentlichen Komponenten ortsnah am Gehäuse 2 anortbar, wodurch eine hochwertige und energiesparende Klimatisierung ermöglicht wird. Durch die beschriebenen Konstruktionsmerkmale des Gehäuses 2 kann dabei der geforderte thermische, hermetische und physisch-mechanische Grundschutz des Innenraums gewährleistet werden. Gemäss einer alternativen Ausführungsform kann mindestens ein Klimamodul 65, 90, 100, vorzugsweise ein Klimamodul 100 zur Flüssigkeitskühlung, auch unabhängig von der Gehäusewand an einem externen Ort aufgestellt werden. Dadurch wird die Möglichkeit geschaffen, neben dem einen oder zwei direkt an dem Gehäuse 2 befestigten Klimamodulen 65, 90, 100 eine zusätzliche Komponente zur Kühlung des Innenraums bereitzustellen.

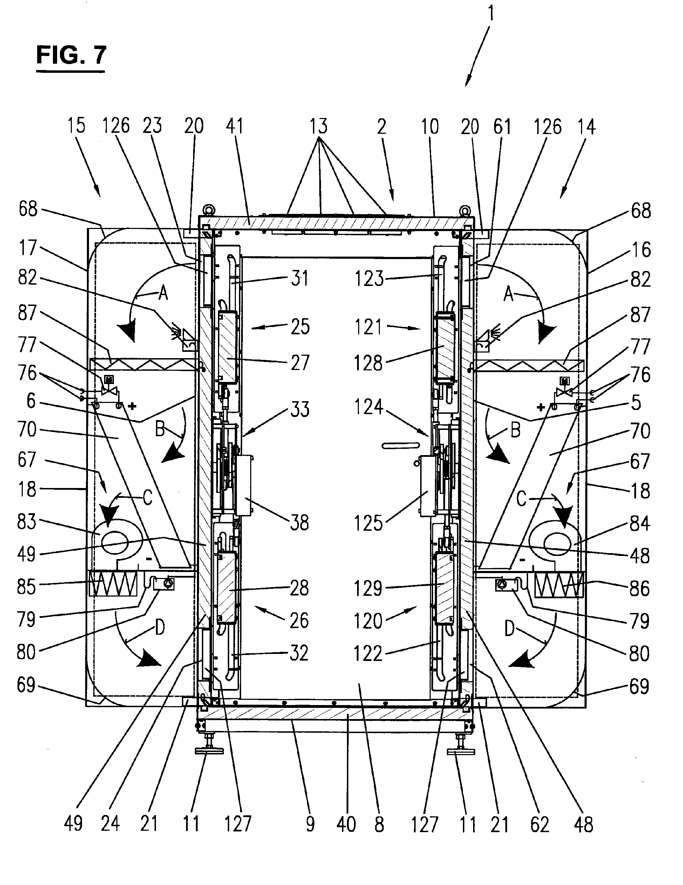

In der Fig. 7 ist ein Querschnitt durch den in Fig. 1 gezeigten Shelter 1 dargestellt, bei welchem die aussenseitig am Gehäuse 2 befestigten Klimamodule 14, 15 durch jeweils ein in Fig. 4 gezeigtes Klimamodul 65 gebildet sind. Anstelle des Klimamoduls 65 mit der Verdampfereinheit 70 als Wärmetauscher kann auch das in Fig. 5 gezeigte Klimamodul 90 mit dem Kaltwasser-Wärmetauscher 92 eingesetzt werden.

Wie in Fig. 7 weiter erkennbar ist, sind an der Innenseite der lateralen Seitenwand 5 zwei Schutzschieber 120, 121 angeordnet, die identisch sind zu den Schutzschiebern 25, 26 der gegenüberliegenden lateralen Seitenwand 6. Die feuerfeste Materialschicht 128, 129 der Schutzschieber 120, 121 besteht also ebenfalls aus einer hochgradig brandisolierenden Kalziumsilikatplatte. Durch die Führungsschienen 122, 123 sind die Schutzschieber 120, 121 zwischen einer Offenstellung und einer Verschlussstellung der Kanalöffnungen 23, 24 in der lateralen Seitenwand 5 verschiebbar gelagert. Zum Verschieben der Schutzschieber 120, 121 ist zudem eine Hebelanordnung 124 und eine Aktivierungseinheit 125 an der Innenseite der Seitenwand 5 angeordnet, die ebenfalls identisch sind zu den entsprechenden Elementen 33, 38 an der gegenüberliegenden Seitenwand 5.

In den oberen und unteren Kanalöffnungen 23, 24 der beiden lateralen Seitenwände 5, 6 sind Luftströmungslamellen 126, 127 angeordnet, durch welche die Strömungsrichtung A der Rückluft vom Gehäuseinnenraum in den Behälterraum und die Strömungsrichtung D der Zuluft vom Behälterraum in den Gehäuseinnenraum begünstigt wird. Im dazwischenliegenden mittleren Behälterabschnitt wird der Luftkreislauf entlang der Strömungsrichtungen B, C durch den Wärmetauscher 70 geleitet. Durch die vorteilhafte Anordnung der Ventilatoren 83, 84 findet dabei eine energieoptimierte Ausnutzung des zur Verfügung stehenden Behältervolumens und der Oberfläche des Wärmetauschers 70 statt.

Durch die zweifache Ausführung und die gegenüberliegende Anordnung der Klimamodule 14, 15 wird neben einer verbesserten Klimatisierung des Innenraums des Gehäuses 2 auch eine erhöhte Betriebssicherheit erreicht. Denn im Bedarfsfall kann die Aufrechterhaltung eines benötigten Innenraumklimas auch durch den Betrieb nur eines der Klimamodule 14, 15 durchgeführt werden. Zu diesem Zweck sind die Klimamodule 14, 15 voneinander getrennt mit einem externen Stromnetz und/oder einer externen Versorgung des Kühlungsmittels verbunden. Erfindungsgemäss können diese Vorteile auch mit einem Shelter 1 erzielt werden, der zwei unterschiedlich ausgebildete Klimamodule 14, 15 aufweist, insbesondere zwei der voranstehend beschriebenen Klimamodule 65, 90, 100.

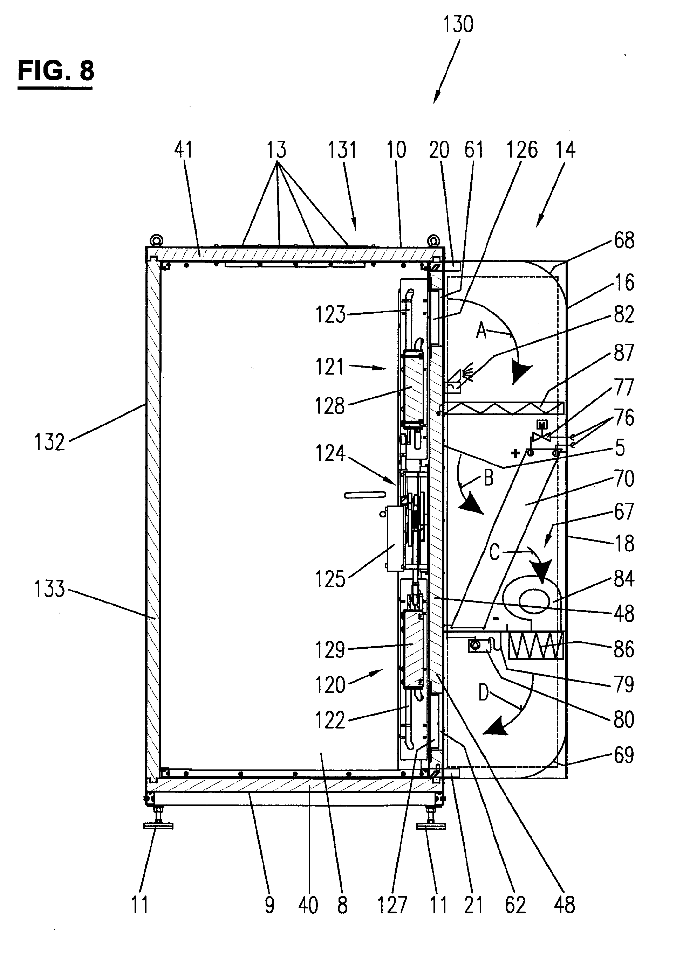

Die Fig. 8 zeigt einen Shelter 130 gemäss einer zweiten Ausführungsform. Der Aufbau des Shelters 130 entspricht im Wesentlichen dem voranstehend beschriebenen Shelter 1, mit dem Unterschied, dass aussenseitig nur ein Klimamodul 14 angeordnet ist. Die vom Klimamodul 14 entgegengesetzt angeordnete Seitenwand 132 des Sheltergehäuses 131 weist eine feuerfeste Materialschicht 133 auf, die durchgängig ortsfest angeordnet ist. Es sind also keine Kanalöffnungen 23, 24 und keine Brandschutzschieber 27, 28 wie bei der Shelterseite 5 mit dem Klimamodul 14 vorhanden. Die feuerfeste Materialschicht 133 besteht aus einer Kalziumsilikatplatte. Der Shelter 130 hat den Vorteil einer kompakteren und kostengünstigeren Bauweise.

Die Fig. 9 zeigt einen Shelter 140 gemäss einer dritten Ausführungsform. Der Aufbau des Shelters 140 entspricht im Wesentlichen dem voranstehend beschriebenen Shelter 1, mit dem Unterschied, dass aussenseitig ein alternativ ausgebildetes zweites Klimamodul 142 anstelle von Klimamodul 15 angeordnet ist. Als zweites Klimamodul 142 wird das in Fig. 6 gezeigte Klimamodul 100 mit dem Wärmetauscher 103 für eine Flüssigkeitskühlung eingesetzt, insbesondere für eine direkte Flüssigkeitskühlung von wassergekühlten Rechnereinheiten.

Das zweite Klimamodul 142 ist aussenseitig an der vom ersten Klimamodul 14 entgegengesetzt angeordneten Seitenwand 143 des Sheltergehäuses 141 angeordnet. Die laterale Seitenwand 143 weist eine feuerfeste Materialschicht 133 auf, die durchgängig ortsfest angeordnet ist und aus einer Kalziumsilikatplatte besteht. Es sind keine Kanalöffnungen 23, 24 und keine Brandschutzschieber 27, 28 wie bei der Shelterseite 5 mit dem Klimamodul 14 vorhanden. Im oberen Bereich der Seitenwand 143 befinden sich brandschützend abgedichtete Durchgangsöffnungen 145, 146 für die Flüssigkeitsleitungen 106, 107.

In diesem oberen Bereich der Seitenwand 143 sind zudem (nicht dargestellte) schnellschliessende Schutzventile für die Flüssigkeitsleitungen 106, 107 angeordnet. Durch diese Schutzventile ist eine brandschützende Abschottung zwischen dem Innenraum des Gehäuses 141 und dem Innenvolumen des Behälters 147 des zweiten Klimamoduls 142 auch innerhalb des Leitungskreislaufs 106, 107 für die Kühlungsflüssigkeit ermöglicht. Die Schutzventile sind vorzugsweise an der Aussenwand des Gehäuses 140 angebracht und sind stromlos schliessbar, beispielsweise bei einer Detektion von Feuer oder Leckwasser oder bei einem Druckverlust im Wasserkreislaufsystem. Dadurch wird der Innenraum des Gehäuses 140 gegen aussen hermetisch abgeschottet.

In der Querschnittsansicht des Klimamoduls 142 in Fig. 9 ist erkennbar, dass durch die schräggestellte Anordnung des Wärmetauschers 104 in dem Behälterraum eine Optimierung der verfügbaren Wärmetauschfläche erreicht wird. Durch die oberseitige Anordnung der Ventilatoren 112 und die Öffnungen 114 im hinteren unteren Behälterbereich wird eine Strömungsrichtung E, F der eintretenden und austretenden Umgebungsluft bewirkt, die eine energieeffiziente Kühlung dieser Wärmetauschfläche erlaubt.

Der Shelter 140 ermöglicht eine gleichzeitige Flüssigkeits-und Luftkühlung der in dem Innenraum des Gehäuses 141 befindlichen Einbauten. Durch die erfindungsgemässe gegenüberliegende Anordnung der entsprechenden Klimamodule 14, 142 wird der klimatisierungstechnische Vorteil einer ortsnahen energiesparenden Unterbringung der Kühlungseinrichtungen 67, 102 mit dem raumökonomischen Vorteil einer kompakten Bauweise des Shelters 140 vereint. Dabei kann als erstes Klimamodul 14 auch das in Fig. 5 gezeigte Klimamodul 90 mit dem Kaltwasser-Wärmetauscher 92 eingesetzt werden.

Eine bevorzugte Verwendung des Shelters 140 besteht in einer gleichzeitigen Unterbringung von flüssigkeitsgekühlten und luftgekühlten Rechnereinheiten. Der Shelter 140 ermöglicht eine vorteilhafte Anordnung beider Klimasysteme im direkten Nebenbereich der Rechnereinheiten. Dennoch sind die Rechnereinheiten von den benachbarten Brandherden und vor Wassereinruch, Diebstahl, etc. hochgradig geschützt.

Ein Shelter gemäss einer vierten Ausführungsform der Erfindung entspricht im Wesentlichen dem in Fig. 9 gezeigten Shelter 140, wobei ein weiteres Klimamodul mit einer dem Klimamodul 142 entsprechenden Bauweise anstelle des ersten Klimamoduls 14 aussenseitig befestigt ist. Dabei ist auch die laterale Seitenwand 5 des Gehäuses 141 entsprechend wie die Seitenwand 143 ausgebildet und es entfällt die Anordnung der Schutzschieber 120, 121 mit dem Aktivierungsmechanismus 124, 125. Auf diese Weise ist ein Shelter mit einer redundanten flüssigkeitsgekühlten Klimatisierung realisiert. Ein solcher Shelter weist ähnliche Vorteile auf wie der in Fig. 7 gezeigte Shelter 1 mit redundanter Luftkühlung.

Ein Shelter gemäss einer fünften Ausführungsform der Erfindung entspricht im Wesentlichen einem der in den Figg. 7-9 gezeigten Shelter 1, 130, 140, wobei die hintere Seitenwand 4 keine Zugangstüre 8 aufweist, sondern im Wesentlichen identisch zu der linken Seitenwand 132 des in Fig. 8 gezeigten Shelters 130 ausgebildet ist. Vorzugsweise sind an der Innenfläche dieser hinteren Seitenwand Regalelemente, insbesondere manuell herausziehbare Trägerplatten, für die im Shelterinnenraum aufzubewahrenden Wertgegenstände angeordnet.

Eine weitere bevorzugte Verwendung der in den Figg. 7-9 gezeigten Shelter 1, 130, 140 besteht in einer längerfristigen geschützten Aufbewahrung von umgebungsempfindlichen Wertgegenständen, insbesondere Gemälden oder anderen Kunstobjekten.

Aus der vorangehenden Beschreibung sind dem Fachmann zahlreiche Abwandlungen des erfindungsgemässen Shelters zugänglich, ohne den Schutzbereich der Erfindung zu verlassen, der alleine durch die Patentansprüche definiert ist.

## Patentansprüche

1. Shelter, insbesondere transportierbarer Shelter, mit einem Gehäuse (2, 131, 141) zur Begrenzung eines klimatisierbaren Innenraums und einem aussenseitig an dem Gehäuse (2, 131, 141) befestigten Behälter (16, 17, 66, 147), der einen Behälterraum zur Aufnahme einer Kühlungseinrichtung (67, 91, 102) aufweist, die zur Kältezuführung in den Innenraum ausgebildet ist **wobei** das Gehäuse (2, 131, 141) mindestens einen Durchgang (23, 61, 145) zur Wärmerückführung vom Innenraum in den Behälterraum aufweist, **dadurch gekennzeichnet, dass** aussenseitig an dem Gehäuse (2, 131, 141) mindestens zwei Behälter (16, 17, 66, 147) zur Aufnahme jeweils einer Kühlungseinrichtung (67, 91, 102) befestigt sind, die voneinander unabhängig zur Kältezuführung in den Innenraum ausgebildet sind, **und** dass in dem einen Behälter (16, 17, 66, 147) eine Kühlungseinrichtung (67, 91, 102) mit einem Wärmetauscher zur Luftkühlung (70, 92) und in dem anderen Behälter (16, 17, 66, 147) eine Kühlungseinrichtung (67, 91, 102) mit einem Wärmetauscher zur Flüssigkeitskühlung (104) angeordnet ist.

2. Shelter nach Anspruch 1, **dadurch gekennzeichnet, dass** das Gehäuse (2, 131, 141) eine feuerfeste Materialschicht (27, 28, 48, 49, 128, 129, 144) zum Abdecken eines Grenzbereichs zwischen dem Behälterraum und dem Innenraum aufweist, um dadurch eine gegenseitige Brandabschottung zu bewirken.

3. Shelter nach Anspruch 2, **dadurch gekennzeichnet, dass** die feuerfeste Materialschicht einen statischen Abschnitt (48, 49, 144) umfasst, der ortsfest in dem Grenzbereich angeordnet ist, und einen aktivierbaren Abschnitt (27, 28, 128, 129), durch den im Brandfall mindestens eine Kanalöffnung (23, 24, 61, 62) zwischen dem Behälterraum und dem Innenraum abdeckbar ist.

4. Shelter nach Anspruch 3, **dadurch gekennzeichnet, dass** der aktivierbare Abschnitt (27, 28, 128, 129) an einer Seitenwand (3, 4, 5, 6, 132, 143) des Gehäuses (2, 131, 141) angeordnet ist und eine Abdeckbreite aufweist, die mindestens zwei Dritteln der Breite, vorzugsweise im Wesentlichen der vollständigen Breite, der Seitenwand (3, 4, 5, 6, 132, 143) entspricht.

5. Shelter nach Anspruch 3 oder 4, **dadurch gekennzeichnet, dass** der aktivierbare Abschnitt (27, 28, 128, 129) durch mindestens einen Schutzschieber (25, 26, 120, 121) gebildet ist, der zwischen einer Offenstellung und einer Verschlussstellung der Kanalöffnung (23, 24, 61, 62) verschiebbar gelagert ist.

6. Shelter nach einem der Ansprüche 2 bis 5, **dadurch gekennzeichnet, dass** in mindestens einer Seitenwand (3, 4, 5, 6, 132, 143) des Gehäuses. (2, 131, 141) die feuerfeste Materialschicht (27, 28, 48, 49, 128, 129, 144) aus einem statischen Abschnitt (48, 49, 144) besteht, der ortsfest in dem Grenzbereich angeordnet ist, wobei durch den Durchgang (145) zur Wärmerückführung hindurch mindestens eine Leitung (106) für einen fluiden Wärmeträger verläuft.

7. Shelter nach einem der Ansprüche 1 bis 5, **dadurch gekennzeichnet, dass** in mindestens einer Seitenwand (3, 4, 5, 6, 132, 143) des Gehäuses (2, 131, 141) zwei Kanalöffnungen (23, 24, 61, 62) angeordnet sind, die in den Behälterraum münden und derart voneinander beabstandet sind, dass im dazwischenliegenden Bereich des Behälterraums ein Wärmetauscher (70, 92, 104) einer Kühlungseinrichtung (67, 91, 102) anortbar ist, die zur Luftzuführung in den Innenraum durch die eine Kanalöffnung (24, 62) und zur Luftrückführung von dem Innenraum durch die andere Kanalöffnung (23, 61) ausgebildet ist.

8. Shelter nach Anspruch 7, **dadurch gekennzeichnet, dass** in dem Behälter (16, 17, 66, 147) mindestens eine Trennplatte (78, 87) mit einem Luftfilter (86, 87) angeordnet ist, durch welche ein unteres Behältervolumen von einem oberen Behältervolumen abgegrenzt ist.

9. Shelter nach einem der Ansprüche 1 bis 8, **dadurch gekennzeichnet, dass** in dem Behälterraum ein Wärmetauscher (70, 92, 104) derart angeordnet ist, dass seine Seitenkanten (72, 96, 105) in Bezug auf eine Rückwand (18) des Behälters (16, 17, 66, 147) schräggestellt sind..

10. Shelter nach Anspruch 9, **dadurch gekennzeichnet, dass** sich der Wärmetauscher (70, 92, 104) im Wesentlichen über die vollständige Breite einer Seitenverkleidung (19) des Behälters (16, 17, 66, 147) erstreckt.

11. Shelter nach Anspruch 9 oder 10, **dadurch gekennzeichnet, dass** im Bereich der Unterkante (73, 97) des Wärmetauschers (70, 92, 104) eine Ventilationseinrichtung (83, 84) angeordnet ist.

12. Shelter nach einem der Ansprüche 1 bis 11, **dadurch gekennzeichnet, dass** in zwei gegenüberliegenden Seitenwänden (3, 4, 5, 6, 132, 143) des Gehäuses (2, 131, 141) jeweils ein Durchgang (23, 61, 145) zur Wärmerückführung angeordnet ist.

13. Shelter nach einem der Ansprüche 1 bis 12, **dadurch gekennzeichnet, dass** sich der Behälter (16, 17, 66, 147) über mindestens zwei Drittel der Breite, vorzugsweise im Wesentlichen über die gesamte Breite, einer Seitenwand (3, 4, 5, 6, 132, 143) des Gehäuses (2, 131, 141) erstreckt.

14. Shelter nach **einem der Ansprüche 1 bis 13**, **dadurch gekennzeichnet, dass** die Behälter (16, 17, 66, 147) an einander entgegengesetzten Seitenwänden (3, 4, 5, 6, 132, 143) des Gehäuses (2, 131, 141) befestigt sind.

15. Shelter nach einem der Ansprüche 1 bis **14**, **dadurch gekennzeichnet, dass** die feuerfeste Materialschicht (27, 28, 48, 49, 128, 129, 144) zumindest abschnittsweise an ihrer äusseren und/oder inneren Oberflächenseite von einer selbsttragenden Verkleidung (44, 45, 46, 47) umgeben ist.

16. Shelter nach einem der Ansprüche 1 bis **15**, **dadurch gekennzeichnet, dass** der Behälter eine Seitenverkleidung (19) aufweist, deren Breite mindestens einem Zehntel der Breite der breitesten Seitenwand (3, 4, 5, 6, 132, 143) des Gehäuses (2, 131, 141) entspricht.

17. Shelter nach einem der Ansprüche 1 bis **16**, **dadurch gekennzeichnet, dass** das Gehäuse (2, 131, 141) mindestens eine Zugangstür (7, 8) zu dem Innenraum aufweist, wobei die Seitenwände (3, 4, 5, 6, 132, 143) zur seitlichen Begrenzung des Innenraums weniger als doppelt so breit sind wie die Breite der Zugangstür (7, 8).

## Claims

1. Shelter, in particular a transportable shelter, comprising an enclosure (2, 131, 141) for delimiting an air-conditionable enclosure interior, and a container (16, 17, 66, 147) that is externally mounted to the enclosure (2, 131, 141) and has a container space for receiving a cooling device (67, 91, 102) that is adapted to cool the enclosure interior, the enclosure (2, 131, 141) comprising at least one passage (23, 61, 145) for heat recirculation from the enclosure interior to the container space, **characterised in that** at least two containers (16, 17, 66, 147) for receiving a respective cooling device (67, 91, 102) are externally mounted to the enclosure (2, 131, 141), the cooling devices being adapted for cooling the enclosure interior independently of each other, and **in that** in one container (16, 17, 66, 147) a cooling device (67, 91, 102) comprising a heat exchanger for air cooling (70, 92) and in the other container (16, 17, 66, 147) a cooling device (67, 91, 102) comprising a heat exchanger for liquid cooling (104) is provided.

2. Shelter according to claim 1, **characterised in that** the enclosure (2, 131, 141) comprises a fire-resistant material layer (27, 28, 48, 49, 128, 129, 144) for covering an interface area between the container space and the enclosure interior in order to achieve a mutual fire separation.

3. Shelter according to claim 2, **characterised in that** the fire-resistant material layer includes a static section (48, 49, 144) that is stationary arranged in the interface area, and an activatable section (27, 28, 128, 129) by which at least one duct opening (23, 24, 61, 62) between the container space and the enclosure interior can be covered in the event of fire.

4. Shelter according to claim 3, **characterised in that** the activatable section (27, 28, 128, 129) is arranged on a side wall (3, 4, 5, 6, 132, 143) of the enclosure (2, 131, 141) and covers a width that corresponds to at least two thirds of the width, preferably substantially the entire width, of the side wall (3, 4, 5, 6, 132, 143).

5. Shelter according to claim 3 or 4, **characterised in that** the activatable section (27, 28, 128, 129) is formed by at least one protection slide (25, 26, 120, 121) that is displaceable between an open position and a closed position of the duct opening (23, 24, 61, 62).

6. Shelter according to one of claims 2 to 5, **characterised in that** in at least one side wall (3, 4, 5, 6, 132, 143) of the enclosure (2, 131, 141) the fire-resistant material layer (27, 28, 48, 49, 128, 129, 144) consists of a static section (48, 49, 144) that is stationary arranged in the interface area, at least one duct (106) for a fluid heat carrier extending through the passage (145) for heat recirculation.

7. Shelter according to one of claims 1 to 6, **characterised in that** in at least one side wall (3, 4, 5, 6, 132, 143) of the enclosure (2, 131, 141) two duct openings (23, 24, 61, 62) are arranged which lead to the container space and are spaced apart in such a manner that in the part of the container space therebetween a heat exchanger (70, 92, 104) of a cooling device (67, 91, 102) can be arranged which is adapted to supply air to the enclosure interior through one of the duct openings (24, 62) and to return air from the enclosure interior through the other duct opening (23, 61) .

8. Shelter according to claim 7, **characterised in that** at least one separating plate (78, 87) with an air filter (86, 87) is arranged in the container (16, 17, 66, 147) by which a lower container volume is delimited from an upper container volume.

9. Shelter according to one of claims 1 to 8, **characterised in that** a heat exchanger (70, 92, 104) is arranged in the container space in such a manner that its lateral borders (72, 96, 105) are inclined relative to a rear wall (18) of the container (16, 17, 66, 147).

10. Shelter according to claim 9, **characterised in that** the heat exchanger (70, 92, 104) substantially extends over the entire width of a lateral casing (19) of the container (16, 17, 66, 147).

11. Shelter according to claim 9 or 10, **characterised in that** in the area of the lower border (73, 97) of the heat exchanger (70, 92, 104) a ventilation device (83, 84) is arranged.

12. Shelter according to one of claims 1 to 11, **characterised in that** in two opposite side walls (3, 4, 5, 6, 132, 143) of the enclosure (2, 131, 141) respective passages (23, 61, 145) for heat recirculation are arranged.

13. Shelter according to one of claims 1 to 12, **characterised in that** the container (16, 17, 66, 147) extends over at least two thirds of the width, preferably substantially over the entire width, of a side wall (3, 4, 5, 6, 132, 143) of the enclosure (2, 131, 141).

14. Shelter according to one of claims 1 to 13, **characterised in that** the containers (16, 17, 66, 147) are mounted to opposite side walls (3, 4, 5, 6, 132, 143) of the enclosure (2, 131, 141).

15. Shelter according to one of claims 1 to 14, **characterised in that** the fire-resistant material layer (27, 28, 48, 49, 128, 129, 144) is at least partially surrounded by a self-supporting sheathing (44, 45, 46, 47) on at least one of its outer and inner surface side.

16. Shelter according to one of claims 1 to 15, **characterised in that** the container comprises a lateral casing (19) whose width corresponds to at least one tenth of the width of the widest side wall (3, 4, 5, 6, 132, 143) of the enclosure (2, 131, 141).

17. Shelter according to one of claims 1 to 16, **characterised in that** the enclosure (2, 131, 141) comprises at least one access door (7, 8) to the enclosure interior, the side walls (3, 4, 5, 6, 132, 143) for the lateral delimitation of the enclosure interior being less than twice as wide as the width of the access door (7, 8).

## Revendications

1. Abri, en particulier un abri transportable, comprenant un boîtier (2, 131, 141) délimitant un espace intérieur climatisable et un réceptacle (16, 17, 66, 147) fixé à l'extérieur du boîtier (2, 131, 141) et ayant un espace de réceptacle destiné à loger un dispositif de refroidissement (67, 91, 102) adapté à refroidir ledit espace intérieur, ledit boîtier (2, 131, 141) comprenant au moins un passage (23, 61, 145) destiné au recyclage de la chaleur de l'espace intérieur à l'espace du réceptacle, **caractérisé en ce qu'**au moins deux réceptacles (16, 17, 66, 147) destinés à loger des dispositifs de refroidissement (67, 91, 102) respectifs sont fixés à l'extérieur du boîtier (2, 131, 141), lesquels dispositifs de refroidissement sont adaptés à refroidir indépendamment ledit espace intérieur, et que dans l'un des réceptacles (16, 17, 66, 147) est agencé un dispositif de refroidissement (67, 91, 102) comprenant un échangeur de chaleur pour refroidissement par air (70, 92) et dans l'autre réceptacle (16, 17, 66, 147) un dispositif de refroidissement (67, 91, 102) comprenant un échangeur de chaleur pour refroidissement par liquide (104).

2. Abri selon la revendication 1, **caractérisé en ce que** le boîtier (2, 131, 141) comprend une couche de matériau (27, 28, 48, 49, 128, 129, 144) résistante au feu pour couvrir une zone limite entre l'espace du réceptacle et l'espace intérieur afin de réaliser ainsi un cloisonnement d'incendie réciproque.

3. Abri selon la revendication 2, **caractérisé en ce que** la couche de matériau résistante au feu comprend une partie statique (48, 49, 144) agencée de manière stationnaire dans la zone limite et une partie activable (27, 28, 128, 129) permettant de couvrir au moins une bouche d'air (23, 24, 61, 62) entre l'espace du réceptacle et l'espace intérieur en cas d'incendie.

4. Abri selon la revendication 3, **caractérisé en ce que** la partie activable (27, 28, 128, 129) est agencée sur une paroi latérale (3, 4, 5, 6, 132, 143) du boîtier (2, 131, 141) et couvre une largeur qui correspond à au moins deux tiers de la largeur, préférablement substantiellement à la largeur entière de la paroi latérale (3, 4, 5, 6, 132, 143).

5. Abri selon la revendication 3 ou 4, **caractérisé en ce que** la partie activable (27, 28, 128, 129) est constituée d'au moins une vanne de protection (25, 26, 120, 121) déplaçable entre une position d'ouverture et une position de fermeture de la bouche d'air (23, 24, 61, 62).

6. Abri selon l'une des revendications 2 à 5, **caractérisé en ce que** dans au moins une paroi latérale (3, 4, 5, 6, 132, 143) du boîtier (2, 131, 141) la couche de matériau résistante au feu (27, 28, 48, 49, 128, 129, 144) est composée d'une partie statique (48, 49, 144) agencée de manière stationnaire dans la zone limite, au moins une conduite (106) pour un caloporteur fluide s'étendant à travers le passage (145) de recyclage de la chaleur.

7. Abri selon l'une des revendications 1 à 6, **caractérisé en ce que** dans au moins une paroi latérale (3, 4, 5, 6, 132, 143) du boîtier (2, 131, 141) sont agencées deux bouches d'air (23, 24, 61, 62) qui débouchent dans l'espace du réceptacle et sont espacées l'une de l'autre de telle manière que dans la partie de l'espace du réceptacle entre elles un échangeur de chaleur (70, 92, 104) d'un dispositif de refroidissement (67, 91, 102) peut être agencé lequel est adapté à amener de l'air à l'espace intérieur par l'une des bouches d'air (24, 62) et recycler l'air de l'espace intérieur par l'autre bouche d'air (23, 61).

8. Abri selon la revendication 7, **caractérisé en ce que** dans le réceptacle (16, 17, 66, 147) est aménagé au moins une plaque de séparation (78, 87) avec un filtre à air (86, 87), laquelle sépare un volume inférieur du réceptacle d'un volume supérieur du réceptacle.

9. Abri selon l'une des revendications 1 à 8, **caractérisé en ce que** dans l'espace du réceptacle est agencé un échangeur de chaleur (70, 92, 104) de telle manière que ses bords latéraux (72, 96, 105) sont inclinés par rapport à une paroi arrière (18) du réceptacle (16, 17, 66, 147).

10. Abri selon la revendication 9, **caractérisé en ce que** l'échangeur de chaleur (70, 92, 104) s'étend substantiellement sur la largeur entière d'un revêtement latéral (19) du réceptacle (16, 17, 66, 147).

11. Abri selon la revendication 9 ou 10, **caractérisé en ce que** dans la zone du bord inférieur (73, 97) de l'échangeur de chaleur (70, 92, 104) est agencé un dispositif de ventilation (83, 84).

12. Abri selon l'une des revendications 1 à 11, **caractérisé en ce que** dans deux paroi latérales opposées (3, 4, 5, 6, 132, 143) du boîtier (2, 131, 141) sont agencés des passages (23, 61, 145) respectifs de recyclage de la chaleur.

13. Abri selon l'une des revendications 1 à 12, **caractérisé en ce que** le réceptacle (16, 17, 66, 147) s'étend sur au moins deux tiers de la largeur, préférablement substantiellement sur la largeur entière, d'une paroi latérale (3, 4, 5, 6, 132, 143) du boîtier (2, 131, 141).

14. Abri selon l'une des revendications 1 à 13, **caractérisé en ce que** les réceptacles (16, 17, 66, 147) sont fixés à des parois latérales (3, 4, 5, 6, 132, 143) opposées du boîtier (2, 131, 141).

15. Abri selon l'une des revendications 1 à 14, **caractérisé en ce que** la couche de matériau résistante au feu (27, 28, 48, 49, 128, 129, 144) est au moins partiellement entourée du côté de sa surface extérieure et/ou intérieure par un revêtement (44, 45, 46, 47) autoporteur.

16. Abri selon l'une des revendications 1 à 15, **caractérisé en ce que** le réceptacle présente un revêtement latéral (19) dont la largeur correspond à au moins un dixième de la largeur de la paroi latérale (3, 4, 5, 6, 132, 143) la plus large du boîtier (2, 131, 141).

17. Abri selon l'une des revendications 1 à 16, **caractérisé en ce que** le boîtier (2, 131, 141) comprend au moins une porte d'accès (7, 8) à l'espace intérieur, les parois latérales (3, 4, 5, 6, 132, 143) délimitant latéralement l'espace intérieur étant moins que deux fois plus larges que la largeur de la porte d'accès (7, 8).
